# FASCICULE DE BREVET EUROPEEN

(11) **EP 3 815 143 B1**
(45) Date de publication et mention de la délivrance du brevet: **22.06.2022**
(21) Numéro de dépôt: 19790611.8
(22) Date de dépôt: 19.06.2019
(51) Int. Cl.: H01L 27/15, H01L 33/54, H01L 33/60, H01L 21/77, H01L 33/58

(54) **PROCÉDÉ DE FABRICATION D'UN DISPOSITIF OPTOÉLECTRONIQUE À PAROIS DE CONFINEMENT LUMINEUX AUTO ALIGNÉS**
VERFAHREN ZUR HERSTELLUNG EINER OPTOELEKTRONISCHEN VORRICHTUNG MIT SELBSTAUSGERICHTETEN LICHTBEGRENZENDEN WÄNDEN
METHOD FOR PRODUCING AN OPTOELECTRONIC DEVICE COMPRISING SELF-ALIGNED LIGHT-CONFINING WALLS

(30) Priorité: 19.06.2018 FR 1855401
(43) Date de publication de la demande: 05.05.2021
(73) Titulaire: Aledia, 38130 Echirolles (FR)
(72) Inventeur: JEANNIN, Olivier, 38000 Grenoble (FR); DORNEL, Erwan, 38800 Champagnier (FR); POURQUIER, Eric, 38000 Grenoble (FR); DUPONT, Tiphaine, 38000 Grenoble (FR)
(74) Mandataire: Germain Maureau
(86) Numéro de dépôt international: PCT/FR2019/051500
(87) Numéro de publication internationale: WO 2019/243741

(56) Documents cités:
- WO-A1-2018/002251
- WO-A1-2018/002485
- FR-A1- 3 000 298
- US-A1- 2015 333 225

## Description

### DOMAINE TECHNIQUE

La présente invention concerne un procédé de fabrication d'un dispositif optoélectronique comportant une matrice de diodes électroluminescentes, défini par la revendication 1.

L'invention concerne également un dispositif optoélectronique en tant que tel, et défini par la revendication 9.

L'invention trouve une application notamment dans les écrans d'affichage ou les systèmes de projection d'images.

### ETAT DE LA TECHNIQUE ANTERIEURE

Par dispositif optoélectronique, on entend ici un dispositif adapté à effectuer la conversion d'un signal électrique en un rayonnement électromagnétique à émettre, notamment de la lumière.

Il existe des dispositifs optoélectroniques comportant des diodes électroluminescentes, également connues sous l'acronyme LED pour « light-emitting diode » selon la terminologie anglo-saxonne consacrée, formées sur un substrat.

Il est connu que chaque diode électroluminescente comprenne un matériau actif exploitant des puits quantiques, une portion semiconductrice dopée selon un premier type de dopage pour jouer le rôle de jonction dopée P et une portion semiconductrice dopée selon un deuxième type de dopage pour jouer le rôle de jonction dopée N.

Chaque diode électroluminescente peut être formée sur la base d'éléments tridimensionnels semiconducteurs, eux-mêmes au moins partiellement obtenus par croissance par épitaxie. Les diodes électroluminescentes sont typiquement formées à base d'un matériau semiconducteur comprenant par exemple des éléments de la colonne III et de la colonne V du tableau périodique, tel qu'un composé III-V, notamment le nitrure de gallium (GaN), le nitrure d'indium et de gallium (InGaN) ou le nitrure d'aluminium et de gallium (AIGaN).

Il existe des dispositifs optoélectroniques comportant une matrice de diodes électroluminescentes présentant une certaine surface d'émission au travers de laquelle est transmis le rayonnement lumineux émis par les diodes électroluminescentes. De tels dispositifs optoélectroniques peuvent notamment être utilisés dans la constitution d'écrans d'affichage ou de systèmes de projection d'images, où la matrice de diodes électroluminescentes définit en fait une matrice de pixels lumineux où chaque pixel comporte une ou plusieurs diodes électroluminescentes.

L'une des difficultés est de parvenir à ce que le rayonnement lumineux émis par une diode électroluminescente ne se mélange pas avec le rayonnement lumineux émis par les diodes électroluminescentes adjacentes afin d'améliorer les contrastes. Notamment, une problématique est de parvenir à éviter les excitations de couleurs de type diaphotie entre les sous-pixels, phénomène également connu sous le nom de « cross-talk » dans le domaine technique concerné. Or, cette problématique s'avère de plus en plus difficile à résoudre compte tenu de la miniaturisation croissante des diodes électroluminescentes.

Une solution connue consiste à former des parois de confinement lumineux aptes à bloquer la transmission du rayonnement lumineux émis par une ou plusieurs diode(s) électroluminescente(s) donnée(s) vers une ou plusieurs diode(s) électroluminescente(s) adjacente(s).

Une technique connue pour former de telles parois de confinement lumineux consiste à déposer une couche de résine sur les diodes électroluminescentes, la résine étant photolithographiée en respectant un motif garantissant la présence de tranchées destinées à être ensuite remplies d'un matériau, par exemple par une technique de croissance ou de dépôt, apte à bloquer le rayonnement lumineux voire à en assurer une réflexion.

Cette technique présente l'inconvénient qu'il est difficile de respecter un alignement précis entre les parois de confinement et les diodes électroluminescentes. Cette problématique est d'autant plus présente compte tenu de la miniaturisation croissante des diodes électroluminescentes afin d'obtenir au final une résolution élevée.

Le document FR3000298A1 décrit une solution dans laquelle une résine négative photosensible dans la gamme de longueurs d'onde d'émission des nanofils photoconducteurs est déposée en recouvrant les nanofils. Avec ce type de résine négative, dans les zones exposées, les photons réagissent avec la résine photosensible négative et dégradent ses propriétés de solubilité, la résine devenant moins soluble. Des motifs sélectifs pourront ensuite être révélés dans un développeur (typiquement une solution aqueuse basique), en effet les zones de la résine peu solubles dans le développeur subsistent ainsi à la surface du substrat, le reste étant solubilisé dans le développeur. La résine peut être choisie de manière à être capable de s'auto-conformer, c'est-à-dire de s'adapter au plus près de la forme des nanofils. L'auto-conformation de la résine permet de laisser des interstices entre deux nanofils adjacents. Puis il est procédé à une étape de dépôt d'une encre dans lesdits interstices, permettant de définir des motifs absorbants de matériau absorbant dans la gamme des longueurs d'onde de sensibilité des nanofils. Puis par injection de courant depuis des plots de commande, on active les nanofils. C'est l'illumination générée par les nanofils qui permet de réaliser l'insolation ou non des différentes parties au sein de la résine. L'intérêt de l'encre absorbante et ainsi des motifs dans les interstices réside dans le fait d'empêcher que la résine qui enrobe un nanofil défectueux soit éclairée par un nanofil voisin. Puis une étape est mise en œuvre au cours de laquelle la résine est développée au niveau des nanofils défectueux, laissant des zones rendues moins solubles et entourant les nanofils actifs uniquement. Puis on retire la couche conductrice qui est présente au-dessus des nanofils défectueux.

Mais cette solution, compte tenu des étapes et des techniques requises, n'est pas encore optimale et ne donne pas une entière satisfaction. Elle est complexe à mettre en œuvre, onéreuse, et reste limitative quant aux techniques et aux matériaux employés.

Dans ce contexte, il existe un besoin de disposer d'un procédé de fabrication d'un dispositif optoélectronique simple, efficace et permettant d'augmenter la résolution tout en optimisant le contraste. Les documents WO2018002485 A1, WO2018002251 A1 et US 2015/333225 A1 décrivent des dispositifs optoélectroniques comprenant une matrice de diodes électroluminescentes où chaque diode présente une forme filaire allongée.

### EXPOSE DE L'INVENTION

La présente invention a pour but de proposer un procédé de fabrication d'un dispositif optoélectronique comprenant une matrice de diodes électroluminescentes qui permette d'obtenir des dispositifs optoélectroniques à haute résolution et à fort contraste de manière simple, économique, efficace et non limitative.

Ce but peut être atteint grâce à la mise en œuvre d'un procédé de fabrication d'un dispositif optoélectronique comportant une matrice de diodes électroluminescentes, comportant les étapes suivantes :
- formation de la matrice de diodes électroluminescentes sur une face support d'un substrat, cette étape étant réalisée de sorte que chaque diode électroluminescente présente une forme filaire allongée suivant un axe longitudinal s'étendant suivant une direction transversale du dispositif optoélectronique orientée transversalement à la face support du substrat,
- formation de parois d'espacement réalisées dans un premier matériau diélectrique et transparent au rayonnement lumineux en provenance des diodes électroluminescentes, les parois d'espacement formées étant telles que les flancs latéraux de chaque diode électroluminescente, sur toute sa hauteur comptée selon la direction transversale, sont entourés par au moins l'une des parois d'espacement,
- formation de parois de confinement lumineux formées dans un deuxième matériau apte à bloquer le rayonnement lumineux en provenance des diodes électroluminescentes, les parois de confinement lumineux formées recouvrant directement les flancs latéraux des parois d'espacement en étant à leur contact, de sorte que le rayonnement lumineux en provenance de chaque diode électroluminescente et dirigé en direction des diodes électroluminescentes adjacentes est bloqué par la paroi de confinement lumineux qui recouvre la paroi d'espacement qui entoure ladite diode électroluminescente,
   dans lequel l'étape de formation de parois de confinement lumineux comprend une étape de dépôt d'une couche mince du deuxième matériau mise en œuvre de sorte que cette couche mince du deuxième matériau recouvre directement les flancs latéraux des parois d'espacement en étant à leur contact et recouvre la bordure supérieure des diodes électroluminescentes et l'étape de dépôt de la couche mince du deuxième matériau comprend une étape de remplissage, par ladite couche mince du deuxième matériau, des espaces vides délimités entre les parois d'espacement au niveau des zones entre les diodes électroluminescentes.

Certains aspects préférés mais non limitatifs de ce procédé de fabrication sont les suivants.

L'étape de formation des parois d'espacement comprend une étape de dépôt d'une couche mince du premier matériau, mise en œuvre de sorte que la couche mince déposée recouvre les flancs latéraux et la bordure supérieure des diodes électroluminescentes.

Après l'étape de dépôt de la couche mince du premier matériau, l'étape de formation des parois d'espacement comprend une étape de gravure de la couche mince du premier matériau précédemment déposée localisée au niveau des bordures supérieures des diodes électroluminescentes et au niveau des zones entre les diodes électroluminescentes.

Le deuxième matériau utilisé dans l'étape de formation des parois de confinement lumineux est tel que les parois de confinement lumineux sont réfléchissantes pour le rayonnement lumineux en provenance des diodes électroluminescentes.

A la fin de l'étape de formation des parois de confinement lumineux, la bordure supérieure de chaque diode électroluminescente n'est pas recouverte par le deuxième matériau de sorte que le rayonnement lumineux en provenance des diodes électroluminescentes est émis hors du dispositif optoélectronique par une surface d'émission du dispositif optoélectronique située, par rapport aux diodes électroluminescentes, du côté des bordures supérieures des diodes électroluminescentes suivant la direction transversale.

A la fin de l'étape de formation des parois de confinement lumineux, la bordure supérieure de chaque diode électroluminescente est recouverte par une paroi de confinement lumineux de sorte qu'après la mise en œuvre d'une étape de retrait du substrat, le rayonnement lumineux en provenance des diodes électroluminescentes est émis hors du dispositif optoélectronique par une surface d'émission du dispositif optoélectronique située, par rapport aux diodes électroluminescentes, du côté opposé aux bordures supérieures des diodes électroluminescentes suivant la direction transversale.

L'étape de formation des parois d'espacement est mise en œuvre de sorte que les parois d'espacement formées présentent une face externe de forme convexe, notamment tronconique, et les parois de confinement lumineux formées présentent une face interne ayant une forme concave complémentaire de ladite forme convexe et tournée vers la diode électroluminescente dont elle confine le rayonnement lumineux.

Le premier matériau utilisé pour la formation des parois d'espacement comporte des particules photoluminescentes qui se présentent sous la forme de boîtes quantiques.

L'invention porte également sur un dispositif optoélectronique comprenant :
- une matrice de diodes électroluminescentes où chaque diode électroluminescente présente une forme filaire allongée suivant un axe longitudinal s'étendant suivant une direction transversale du dispositif optoélectronique,
- des parois d'espacement réalisées dans un premier matériau diélectrique et transparent au rayonnement lumineux en provenance des diodes électroluminescentes et agencées de telle sorte que les flancs latéraux de chaque diode électroluminescente, sur toute sa hauteur comptée selon la direction transversale, sont entourés par au moins l'une des parois d'espacement,
- et des parois de confinement lumineux formées dans un deuxième matériau apte à bloquer le rayonnement lumineux en provenance des diodes électroluminescentes, les parois de confinement lumineux recouvrant directement les flancs latéraux des parois d'espacement en étant à leur contact, le rayonnement lumineux en provenance de chaque diode électroluminescente et dirigé en direction des diodes électroluminescentes adjacentes étant bloqué par la paroi de confinement lumineux qui recouvre la paroi d'espacement qui entoure ladite diode électroluminescente,
   dans lequel les parois de confinement lumineux sont formées par une couche mince du deuxième matériau obtenue par un dépôt mis en œuvre de sorte que la couche mince recouvre directement les flancs latéraux des parois d'espacement en étant à leur contact et recouvre la bordure supérieure des diodes électroluminescentes et les espaces vides délimités entre les parois d'espacement au niveau des zones entre les diodes électroluminescentes sont remplis par ladite couche mince du deuxième matériau.

Certains aspects préférés mais non limitatifs de ce dispositif optoélectronique sont les suivants.

Les parois de confinement lumineux recouvrent la bordure supérieure des diodes électroluminescentes et le rayonnement lumineux en provenance des diodes électroluminescentes est émis hors du dispositif optoélectronique par une surface d'émission du dispositif optoélectronique située, par rapport aux diodes électroluminescentes, du côté opposé aux bordures supérieures des diodes électroluminescentes suivant la direction transversale.

Le deuxième matériau est tel que les parois de confinement lumineux sont réfléchissantes pour le rayonnement lumineux en provenance des diodes électroluminescentes et les parois d'espacement présentent une face externe de forme convexe et les parois de confinement lumineux présentent une face interne ayant une forme concave complémentaire de ladite forme convexe et tournée vers la diode électroluminescente dont elle confine le rayonnement lumineux.

Le dispositif optoélectronique comprend une couche d'électrode inférieure formée dans un matériau électriquement conducteur et transparent au rayonnement lumineux, ladite couche d'électrode inférieure étant en contact électrique avec les bordures inférieures des diodes électroluminescentes afin de remplir une fonction de première électrode commune à plusieurs diodes électroluminescentes.

Chaque diode électroluminescente est de type cœur-coquille et le dispositif optoélectronique comprend une couche d'électrode supérieure formée dans un matériau électriquement conducteur et transparent au rayonnement lumineux, la couche d'électrode supérieure recouvrant directement les flancs latéraux et la bordure supérieure des diodes électroluminescentes en étant à leur contact de sorte à remplir une fonction de seconde électrode commune à plusieurs diodes électroluminescentes, les parois d'espacement recouvrant directement les flans latéraux et la bordure supérieure de la couche d'électrode supérieure en étant à leur contact et la couche d'électrode supérieure étant en contact électrique avec au moins l'une des parois de confinement lumineux.

Les parois de confinement lumineux ne recouvrent pas la bordure supérieure des diodes électroluminescentes et le rayonnement lumineux en provenance des diodes électroluminescentes est émis hors du dispositif optoélectronique par une surface d'émission du dispositif optoélectronique située, par rapport aux diodes électroluminescentes, du côté des bordures supérieures des diodes électroluminescentes suivant la direction transversale.

### BREVE DESCRIPTION DES DESSINS

D'autres aspects, buts, avantages et caractéristiques de l'invention apparaîtront mieux à la lecture de la description détaillée suivante de modes de réalisation préférés de celle-ci, donnée à titre d'exemple non limitatif, et faite en référence aux dessins annexés sur lesquels :
Les figures 1 à 5 illustrent différentes étapes d'un premier exemple de mise en œuvre d'un procédé de fabrication selon l'invention.
La figure 6 illustre une variante de la figure 5.
Les figures 7 et 8 représentent, en vue de dessus, deux exemples de dispositifs optoélectroniques fabriqués par la mise en œuvre du procédé de fabrication des figures 1 à 5.
Les figures 9 et 10 représentent, en coupe longitudinale, deux autres exemples de dispositifs optoélectroniques qui peuvent être obtenus pas la mise en œuvre d'un procédé de fabrication selon l'invention.
Les figures 11 et 12 illustrent deux étapes d'un deuxième exemple de mise en œuvre d'un procédé de fabrication selon l'invention.
La figure 13 illustre une variante de la figure 12.
La figure 14 représente, en coupe longitudinale, un autre exemple de dispositif optoélectronique qui peut être obtenu par la mise en œuvre d'un procédé de fabrication selon l'invention.

### EXPOSE DETAILLE DE MODES DE REALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux.

L'invention porte d'abord sur un procédé de fabrication d'un dispositif optoélectronique 10 comportant une matrice de diodes électroluminescentes 11. Elle porte aussi sur un dispositif optoélectronique 10 en tant que tel, comportant la matrice de diodes électroluminescentes 11.

Grâce à l'aménagement d'une telle matrice de diodes électroluminescentes 11, une application particulièrement visée est la fourniture d'un écran d'affichage d'images ou d'un dispositif de projection d'images.

A cet effet, la matrice de diodes électroluminescentes 11 peut présenter une certaine surface d'émission au travers de laquelle est transmis le rayonnement lumineux en provenance des diodes électroluminescentes 11. La matrice de diodes électroluminescentes 11 définit en pratique une matrice de pixels lumineux où chaque pixel comporte une ou plusieurs diodes électroluminescentes 11. Notamment, chaque pixel peut comprendre :
- au moins un sous-pixel formé d'au moins une diode électroluminescente 11 apte à générer directement, ou à transmettre par l'intermédiaire d'un convertisseur de lumière adapté, de la lumière bleue,
- au moins un sous-pixel formé d'au moins une diode électroluminescente 11 apte à générer directement, ou à transmettre par l'intermédiaire d'un convertisseur de lumière adapté, de la lumière verte,
- au moins un sous-pixel formé d'au moins une diode électroluminescente 11 apte à générer directement, ou à transmettre par l'intermédiaire d'un convertisseur de lumière adapté, de la lumière rouge.

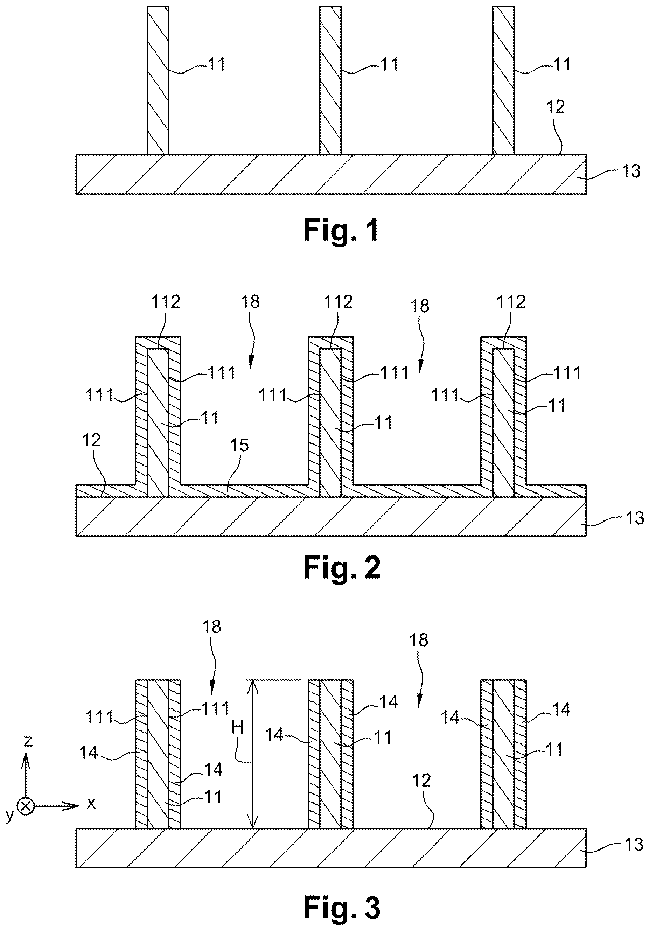

Les figures 1 à 5 illustrent différentes étapes d'un premier exemple de mise en œuvre d'un procédé de fabrication selon l'invention.

En référence d'abord à la figure 1, le procédé de fabrication comprend une étape de formation de la matrice de diodes électroluminescentes 11 sur une face support 12 d'un substrat 13.

Pour faciliter la compréhension, on définit ici et pour la suite de la description un repère direct tridimensionnel (X, Y, Z) où le plan (X, Y) correspond au plan principal du dispositif optoélectronique 10 dans lequel les diodes électroluminescentes 11 sont réparties et où Z correspond à la direction transversale du dispositif optoélectronique 10 orientée transversalement au plan (X, Y). Autrement dit, les directions X et Y sont globalement orientées parallèlement au plan général de la face support 12 du substrat 11 servant à la fabrication du dispositif optoélectronique 10 et la direction transversale Z est orientée transversalement à la face support 12 du substrat 13.

Durant cette étape, chaque diode électroluminescente 11 formée présente avantageusement une forme filaire allongée suivant un axe longitudinal s'étendant suivant la direction transversale Z du dispositif optoélectronique 10.

L'organisation de chaque diode électroluminescente 11 sous la forme d'un fil est très avantageuse pour des dispositifs optoélectroniques 10 à haute résolution et à fort contraste tout en ne générant pas de limitation quant aux matériaux et aux techniques utilisés dans les étapes suivantes du procédé de fabrication et en conférant tous les avantages connus quant au recours à de telles diodes électroluminescentes 11 filaires, notamment en terme de coût et d'efficacité.

Les techniques mises en œuvre pour former les diodes électroluminescentes 11 filaires ne sont pas limitatives en ce qui concerne le procédé de fabrication décrit dans ce document de sorte que pour mettre en œuvre cette étape de formation des diodes électroluminescentes 11, l'Homme du Métier pourra avoir recours à toutes les techniques connues.

De manière non illustrée en détail, chaque diode électroluminescente 11 comprend des éléments semiconducteurs dont une première portion dopée, une partie active et une seconde portion dopée. Les éléments semiconducteurs sont agencés sous une forme filaire, selon des dimensions micrométriques ou nanométriques.

Chaque diode électroluminescente 11 sous la forme d'un fil peut indifféremment être de type cœur-coquille ou alternativement peut présenter une structure axiale où la première portion dopée, la partie active et la deuxième portion dopée sont empilées selon la direction transversale Z. Toutes les techniques connues à ces fins peuvent être utilisées, notamment en exploitant les principes connus de croissance épitaxiale.

La section droite des diodes électroluminescentes 11 filaires, prises dans tout plan parallèle au plan (X, Y), peut avoir différentes formes telles que, par exemple, une forme ovale, circulaire ou polygonale (par exemple carrée, rectangulaire, triangulaire ou hexagonale).

Par exemple dans le cas d'une organisation de type cœur-coquille, chaque diode électroluminescente 11 comprend un fil formant la première portion dopée, qu'elle soit de type N ou de type P, s'étendant transversalement au plan de la face support 12 du substrat 13, et une coque recouvrant au moins la partie supérieure de ce fil. La coque peut comprendre un empilement de plusieurs couches de matériaux semiconducteurs, notamment au moins une couche formant la partie active recouvrant au moins la partie supérieure du fil et une couche formant la seconde portion dopée et recouvrant la couche formant la partie active.

A titre d'exemple, les fils constitutifs de la première portion dopée peuvent être, au moins en partie, formés à partir de matériaux semiconducteurs comportant majoritairement un composé III-V, par exemple des composés III-N. Des exemples du groupe III comprennent le gallium, l'indium ou l'aluminium. Des exemples de composés III-N sont GaN, AIN, InGaN ou AlInGaN. D'autres éléments du groupe V peuvent également être utilisés, par exemple, le phosphore, l'arsenic ou l'antimoine. De façon générale, les éléments dans le composé III-V peuvent être combinés avec différentes fractions molaires. Il convient de préciser que les fils peuvent indifféremment être formés à partir de matériaux semiconducteurs comportant majoritairement un composé II-VI. Le dopant peut être choisi, dans le cas d'un composé III-V, parmi le groupe comprenant un dopant de type P du groupe II, par exemple du magnésium, du zinc, du cadmium ou du mercure, un dopant du type P du groupe IV par exemple du carbone, ou un dopant de type N du groupe IV, par exemple du silicium, du germanium ou du sélénium.

La partie active est la couche depuis laquelle est émise la majorité du rayonnement fourni par la diode électroluminescente 11. Elle peut comporter des moyens de confinement des porteurs de charge électrique, tels que des puits quantiques. Elle est, par exemple, constituée d'une alternance de couches de GaN et d'InGaN. Les couches de GaN peuvent être dopées. Alternativement, la couche active peut être constituée par une unique couche d'InGaN.

La couche formant la seconde portion dopée, dopée de type P si les fils sont dopés de type N ou dopée de type N si les fils sont dopés de type P, peut correspondre à une couche semi-conductrice ou à un empilement de couches semiconductrices permettant la formation d'une jonction P-N ou P-I-N.

De manière générale, la première portion dopée des diodes électroluminescentes 11 est en contact électrique avec une première électrode inférieure et la seconde portion dopée des diodes électroluminescentes 11 est en contact électrique avec une deuxième électrode supérieure. Ces considérations seront approfondies dans la suite uniquement à titre d'exemple.

La manière de former la première électrode inférieure et la deuxième électrode supérieure ne sont pas limitatives et toutes les techniques connues, et adaptées à la mise en œuvre des étapes ultérieures qui vont être décrites dans la suite de la description, peuvent au contraire être envisagées par l'Homme du Métier. Par exemple, la première électrode inférieure peut être formée par le substrat 13 lui-même ou par une couche conductrice formée sur la face support 12 du substrat 13. La première électrode inférieure peut également être formée après le retrait du substrat 13.

Il est donc insisté sur le fait que les termes « formation de la matrice de diodes électroluminescentes 11 sur la face support 12 » signifie soit que les diodes électroluminescentes 11 sont directement formées sur la face support 12 moyennant un contact mécanique et électrique, soit que les diodes électroluminescentes 11 sont indirectement formées sur la face support 12 moyennant interposition au moins de la couche conductrice destinée à assurer la fonction de première électrode inférieure.

Le substrat 13 peut donc être au moins partiellement formé dans un matériau conducteur ou semiconducteur fortement dopé de sorte à avoir de bonnes propriétés de conductivité électrique, par exemple constitué en silicium de préférence monocristallin.

Le substrat 13 peut aussi être formé en saphir voire en un matériau semiconducteur III-V, par exemple en GaN.

Il peut alternativement s'agir d'un substrat de type silicium sur isolant ou « SOI » pour « Silicon On Insulator » selon la terminologie anglo-saxonne consacrée.

Alternativement, le substrat 13 peut être formé dans un matériau semiconducteur ou électriquement isolant.

Il ressort de ce qui précède que la première électrode inférieure peut être formée par le substrat 13 lui-même ou par une couche d'électrode inférieure 21, formée sur le substrat 13 dans un matériau électriquement conducteur et en contact électrique avec les bordures inférieures des diodes électroluminescentes 11 afin de remplir une fonction de première électrode commune à plusieurs diodes électroluminescentes 11.

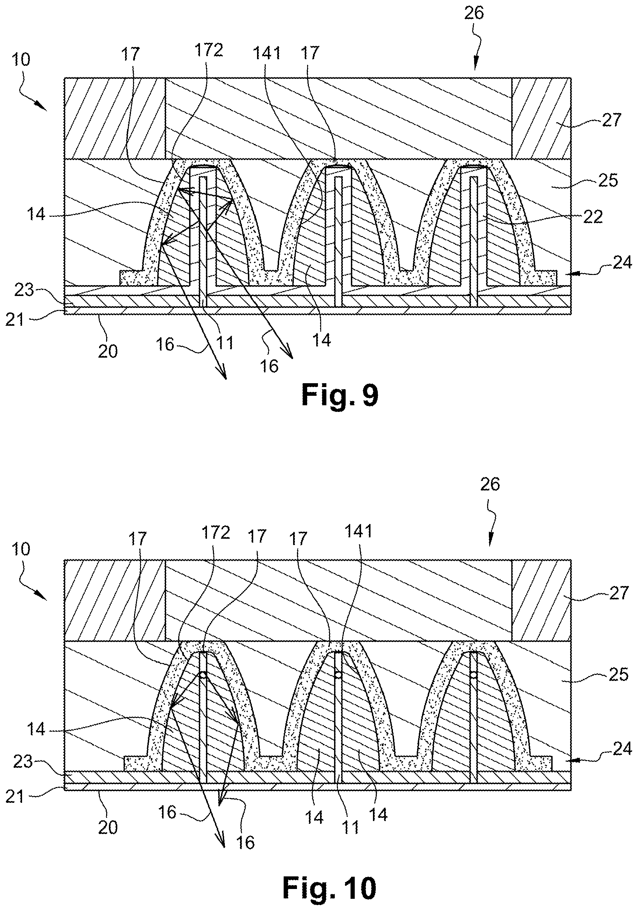

Dans le cas où une émission de la lumière sera recherchée en face arrière du dispositif optoélectronique 10, comme c'est par exemple le cas dans les modes de réalisation des figures 9 et 10, la couche d'électrode inférieure 21 peut être transparente au rayonnement lumineux 16 en provenance des diodes électroluminescentes 11 (il est précisé que dans ce mode de réalisation, le substrat 13 sur lequel les diodes électroluminescentes 11 sont formées est retiré et la couche d'électrode inférieure 21 est formée après le retrait du substrat 13). Mais il est précisé que cette condition de transparence de la couche 21 au rayonnement lumineux 16 n'est pas obligatoire, notamment dans le cas où il sera souhaité que l'émission de la lumière se fasse du côté de la face avant du dispositif optoélectronique 10.

Il est possible de prévoir une couche de matériau électriquement isolant entre le substrat 13 et la couche d'électrode inférieure 21, par exemple en fonction de la nature du substrat 13, une telle couche de matériau électriquement isolant restant toutefois facultative.

La couche d'électrode inférieure 21 peut comprendre une couche de nucléation ou un empilement de couches de nucléation formées dans un matériau adapté à la croissance, sur ledit matériau, des éléments semiconducteurs des diodes électroluminescentes 11.

A titre d'exemple, le matériau composant une couche de nucléation peut être un nitrure, un carbure ou un borure d'un métal de transition de la colonne IV, V ou VI du tableau périodique des éléments ou une combinaison de ces composés. A titre d'exemple, la couche de nucléation peut être en nitrure d'aluminium, en oxyde d'aluminium, en bore, en nitrure de bore, en titane, en nitrure de titane, en tantale, en nitrure de tantale, en hafnium, en nitrure d'hafnium, en niobium, en nitrure de niobium, en zirconium, en borure de zirconium, en nitrure de zirconium, en carbure de silicium, en nitrure et carbure de tantale, ou en nitrure de magnésium sous la forme MgₓN_{y}, où x est environ égal à 3 et y est environ égal à 2, par exemple du nitrure de magnésium sous la forme Mg₃N₂. La couche de nucléation peut être dopée du même type de conductivité que celle des éléments semiconducteurs destinés à croître, et présenter une épaisseur par exemple comprise entre 1 nm et 200 nm, de préférence comprise entre 10 nm et 50 nm. La couche de nucléation peut être composée d'un alliage ou d'un empilement d'un ou de plusieurs matériaux mentionnés dans la liste ci-dessus.

La couche d'électrode inférieure 21 peut comprendre, en plus de la ou les couches de nucléation ou à la place de la ou les couches de nucléation, une couche conductrice ou un empilement de couches conductrices, notamment de nature métallique.

Dans le cas où il sera recherché une émission de la lumière du côté de la face avant du dispositif optoélectronique 10, la ou les couches conductrices peuvent recouvrir la ou les couches de nucléation entre les diodes électroluminescentes 11 mais sans s'étendre sur les diodes électroluminescentes 11. Le matériau conducteur utilisé pour de telles couches conductrices est par exemple : aluminium, cuivre, or, ruthénium, argent, zinc, titane, nickel. Il pourra notamment être recherché des propriétés lui permettant de jouer un rôle de réflecteur pour renvoyer vers l'extérieur les rayonnement lumineux 16 initialement émis par les diodes électroluminescentes 11 en direction du substrat 13.

Dans le cas où il sera recherché une émission de la lumière du côté de la face arrière du dispositif optoélectronique 10, le matériau conducteur utilisé pour de telles couches conductrices pourra présenter des caractéristiques de transparence à la lumière émis par les diodes électroluminescentes 11. Le matériau utilisé peut par exemple être choisi parmi tous les oxydes transparents conducteurs connus de l'Homme du Métier, également connus sous l'acronyme « TCO » pour « Transparent Conductive Oxide » en anglais. Il pourra notamment être prévu de former la ou les couches conductrices, par exemple par dépôt, après une étape de retrait du substrat 13 et de retrait de la ou les couches de nucléation.

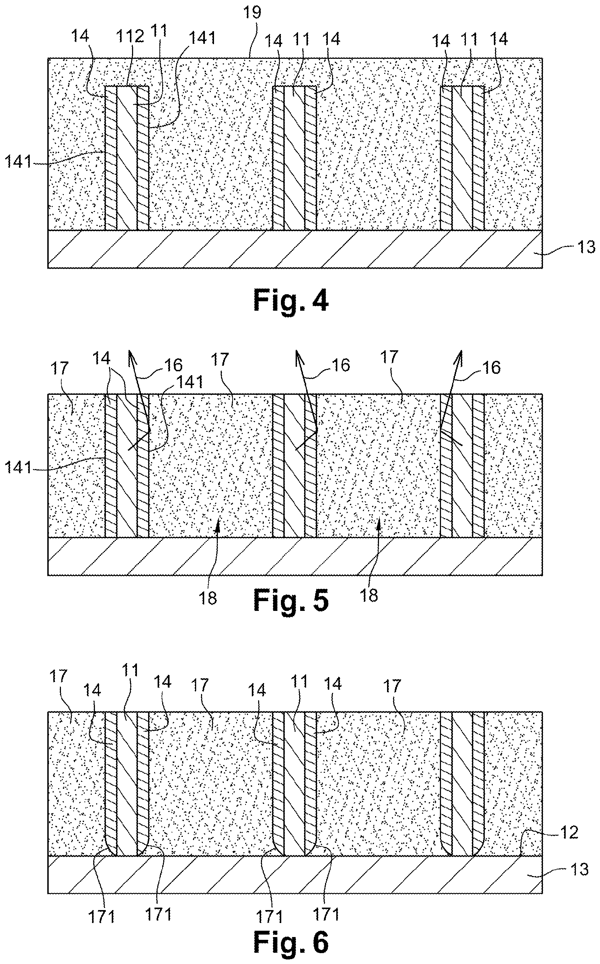

Le procédé de fabrication comprend ensuite, en référence à la figure 3, une étape de formation de parois d'espacement 14 réalisées dans un premier matériau à la fois diélectrique et transparent au rayonnement lumineux 16 (ce rayonnement lumineux étant schématisé par des flèches subissant une réflexion sur la figure 5) en provenance des diodes électroluminescentes 11. Les parois d'espacement 14 sont formées de sorte que les flancs latéraux 111 de chaque diode électroluminescente 11, sur toute sa hauteur H comptée selon la direction transversale Z, sont entourés par au moins l'une des parois d'espacement 14. A titre d'exemple, la hauteur H des diodes électroluminescentes 11 est comprise entre 0,1 et 100 µm, préférentiellement entre 0.5 et 20 µm.

Le premier matériau utilisé pour la formation des parois d'espacement 14 présente donc des propriétés de transparence aux longueurs d'ondes prévues pour les rayonnements lumineux 16 en provenance des parties actives des diodes électroluminescentes 11 et en même temps des propriétés d'isolation électrique. Il peut par exemple s'agir d'un oxyde, d'un nitrure voire par exemple d'un oxynitrure de silicium. D'autres matériaux peuvent également convenir, comme par exemple des matériaux organiques, certaines résines ou silicones, du TiO₂ ou du HfO₂.

Le premier matériau utilisé pour la formation des parois d'espacement 14 peut comporter des particules photoluminescentes, adaptées pour convertir le rayonnement lumineux 16 émis par les diodes électroluminescentes 11 en termes de longueurs d'ondes, afin de modifier au final la couleur de la lumière émise hors du dispositif optoélectronique 10. Cette solution peut être utilisée pour obtenir des pixels ou des sous-pixels de différentes couleurs sans avoir à recourir à d'autres convertisseurs de couleurs additionnels.

De préférence, les particules photoluminescentes se présentent sous la forme de boîtes quantiques (ou « quantum dots » selon la terminologie anglo-saxonne appropriée), c'est-à-dire sous la forme de nano-cristaux semiconducteurs dont le confinement quantique est sensiblement tridimensionnel. La taille moyenne des boîtes quantiques peut alors être comprise entre 0,2 nm et 50 nm, par exemple entre 1 nm et 30 nm. Les boîtes quantiques peuvent être formées d'au moins un composé semiconducteur, qui peut être choisi parmi le séléniure de cadmium (CdSe), le phosphore d'indium (InP), le phosphore de gallium et d'indium (InGaP), le sulfure de cadmium (CdS), le sulfure de zinc (ZnS), l'oxyde de cadmium (CdO) ou de zinc (ZnO), le séléniure de zinc et de cadmium (CdZnSe), le séléniure de zinc (ZnSe) dopé par exemple au cuivre ou au manganèse, le graphène ou parmi d'autres matériaux semiconducteurs pouvant convenir. La taille et la composition des particules photoluminescentes sont choisies en fonction de la longueur d'onde de luminescence désirée. Il peut s'agir de structures de type cœur-coquille également.

De manière générale, toute technique peut être envisagée par l'Homme du Métier pour former de telles parois d'espacement 14.

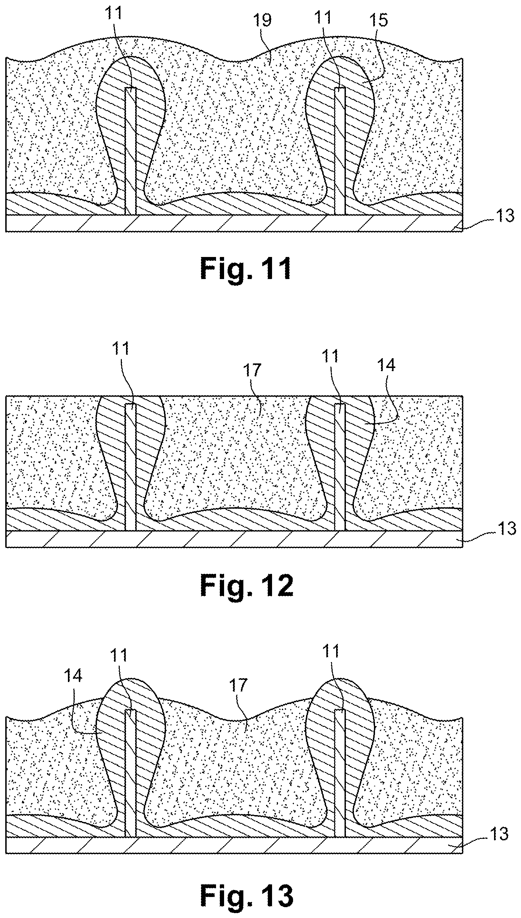

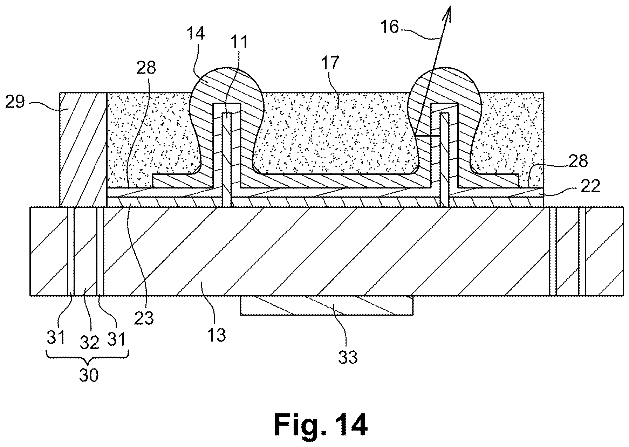

A l'issue de leur étape de formation, en fonction de l'organisation générale recherchée pour le dispositif optoélectronique 10, les parois d'espacement 14 peuvent être agencées de sorte à ne pas recouvrir les bordures supérieures 112 des diodes électroluminescentes 11 comme cela est représenté sur les exemples des figures 5, 6, 9 et 10, ou alternativement les parois d'espacement 14 peuvent être agencées de sorte à les recouvrir comme cela est représenté sur les exemples des figures 13 et 14.

Selon un mode particulier de mise en œuvre du procédé de fabrication non limitatif, en référence à la figure 2, l'étape de formation des parois d'espacement 14 comprend une étape de dépôt d'une couche mince 15 du premier matériau, mise en œuvre de sorte que la couche mince 15 déposée recouvre les flancs latéraux 111 et la bordure supérieure 112 des diodes électroluminescentes 11. La couche mince 15 peut recouvrir directement les flancs latéraux 111 et les bordures supérieures 112 des diodes électroluminescentes 11 en étant à leur contact. Alternativement, la couche mince 15 peut les recouvrir indirectement moyennant interposition d'au moins une couche intermédiaire comme par exemple au moins une couche mince de matériau conducteur et transparent aux rayonnements lumineux 16 destinée à remplir le rôle de la seconde électrode supérieure. Ces dispositions sont par exemple représentées sur la figure 9 avec la présence de la couche repérée 22 qui sera décrite plus en détails dans la suite de la description.

La couche mince 15 peut être déposée par dépôt chimique en phase vapeur (ou « Chemical Vapor Deposition », en anglais), par exemple par dépôt de couche mince atomique (ou « Atomic Layer Deposition », en anglais), voire par dépôt physique en phase vapeur (ou « Physical Vapor Deposition », en anglais), par exemple par faisceau d'électrons, par pulvérisation cathodique, ou autre.

La couche mince 15 peut être déposée selon une technique de dépôt conforme (cas des figures 3 et 4 par exemple), ou par une technique de dépôt où l'épaisseur de la couche mince 15 déposée n'est pas constante comme cela est représenté sur les figures 11 à 13.

Par « dépôt conforme », on entend le dépôt d'une couche mince 15 sur les diodes électroluminescentes 11 de sorte qu'elle s'étende localement de manière sensiblement parallèle à la surface qu'elle recouvre. La couche mince 15 déposée de manière conforme présente une épaisseur sensiblement homogène. L'épaisseur locale peut toutefois varier entre une valeur minimale au niveau par exemple d'une surface sensiblement orthogonale au plan (X, Y) et une valeur maximale au niveau par exemple d'une surface sensiblement parallèle au plan (X, Y). A titre purement illustratif, pour un dépôt conforme d'une couche mince de 1 µm, l'épaisseur de la couche mince 15 peut varier entre une valeur de 500 nm au niveau des flancs latéraux 111 des diodes électroluminescentes 11 et une valeur de 1 µm au niveau des bordures supérieures 112 des diodes électroluminescentes 11.

De manière générale, la couche mince 15 présente une épaisseur moyenne (cette épaisseur moyenne étant sensiblement homogène dans le mode de réalisation particulier prévoyant un dépôt conforme de matière) qui peut être comprise entre 100 nm et 10 µm, et de préférence entre 500 nm et 5 µm, par exemple comprise entre 1 µm et 2 µm, au niveau des flancs latéraux 111 des diodes électroluminescentes 11.

L'épaisseur de la couche mince 15 peut notamment résulter d'un compromis entre sa fonction d'auto-alignement des parois de confinement lumineux 17 décrites plus loin, et la fourniture de la meilleure résolution possible.

Ainsi, comme cela est visible sur la figure 2, la couche mince 15 peut recouvrir continûment les flancs latéraux 111 des diodes électroluminescentes 11, leurs bordures supérieures 112 et les zones 18 entre les diodes électroluminescentes 11.

Dans le deuxième exemple de mise en œuvre du procédé de fabrication représenté sur les figures 11 et 12, le dépôt de la couche mince 15 se pratique de manière non conforme, en ce sens que l'épaisseur de la couche mince 15 présente, après dépôt, de grandes variations. En particulier, l'épaisseur de la couche mince 15 diminue progressivement en s'approchant de la zone de liaison entre les diodes électroluminescentes 11 et le substrat 13, c'est-à-dire au niveau de leurs bordures inférieures. Cette diminution progressive se pratique tant le long des flancs latéraux 111 des diodes électroluminescentes 11 que le long des zones séparant les diodes électroluminescentes 11 entre elles.

Selon un mode particulier non limitatif de mise en œuvre du procédé de fabrication, afin d'aboutir par exemple à la configuration temporaire de la figure 3, après l'étape de dépôt de la couche mince 15 du premier matériau, l'étape de formation des parois d'espacement 14 comprend une étape facultative de gravure de la couche mince 15 de premier matériau précédemment déposée, cette gravure étant localisée au niveau des bordures supérieures 112 des diodes électroluminescentes 11 et au niveau des zones 18 entre les diodes électroluminescentes 11.

Ainsi, on grave les parties de la couche mince 15 non situées au niveau des flancs latéraux 111 des diodes électroluminescentes 11. On supprime ainsi les parties de la couche mince 15 qui recouvrent les bordures supérieures 112 des diodes électroluminescentes et les zones 18 situées entre les diodes électroluminescentes 11. Autrement dit, les parois d'espacement 14 recouvrent les flancs latéraux 111 des diodes électroluminescentes 11 continûment, ce qui facilite la formation ultérieure des parois de confinement lumineux 17 directement à leur contact.

Cette étape de gravure peut être effectuée par gravure sèche, par exemple par gravure par plasma (RIE, ICP...). La gravure sèche étant fortement anisotrope, seules restent les parties de la couche mince 15 recouvrant les flancs latéraux 111 des diodes électroluminescentes 11, formant ainsi des parois d'espacement 14 qui entourent les diodes électroluminescentes 11 dans un plan parallèle au plan (X, Y), comme cela est visible sur la figure 3.

Il reste néanmoins que cette étape de gravure est facultative de sorte que les parois d'espacement 14 peuvent tout à fait recouvrir directement ou indirectement les bordures supérieures des diodes électroluminescentes 11, comme c'est par exemple le cas sur les figures 11 à 14. Dans le cas où cette gravure de la couche mince 15 n'est pas pratiquée après le dépôt de la couche mince 15, les parois d'espacement 14 correspondront essentiellement à la couche mince 15 formée. Dans le cas où cette gravure de la couche mince 15 est réalisée, les parois d'espacement 14 correspondront essentiellement aux reliquats de la couche mince 15 après gravure.

Le procédé de fabrication comprend ensuite, en référence par exemple à la figure 5, une étape de formation de parois de confinement lumineux 17 formées dans un deuxième matériau apte à bloquer le rayonnement lumineux 16 en provenance des diodes électroluminescentes 11. Par « bloquer le rayonnement lumineux », on entend soit que le matériau absorbe le rayonnement lumineux incident afin qu'il ne traverse pas ce matériau, soit que le matériau présente des propriétés de réflexion du rayonnement lumineux incident sur ce matériau.

Les parois de confinement lumineux 17 formées recouvrent directement les flancs latéraux 141 des parois d'espacement 14 en étant à leur contact, de sorte que le rayonnement lumineux 16 en provenance de chaque diode électroluminescente 11 et dirigé en direction des diodes électroluminescentes 11 adjacentes est bloqué (par absorption ou réflexion) par la paroi de confinement lumineux 17 qui recouvre la paroi d'espacement 14 qui entoure cette diode électroluminescente 11.

Par « rayonnement lumineux 16 en provenance des diodes électroluminescentes 11 », on entend qu'il s'agit des rayonnements lumineux directement émis par les diodes électroluminescentes 16, soit qu'il s'agit des rayonnements lumineux convertis par d'éventuels convertisseurs de couleur, par exemple par l'intermédiaire de particules photoluminescentes dans le premier matériau utilisé pour la formation des parois d'espacement 14.

La présence de telles paroi de confinement lumineux 17 permet d'éviter que les rayonnements lumineux 16 en provenance des diodes électroluminescentes 11 ne se mélangent entre eux d'une diode électroluminescente 11 à l'autre afin de pouvoir disposer d'un fort contraste.

Autrement dit, s'il est possible de prévoir que le deuxième matériau utilisé dans l'étape de formation des parois de confinement lumineux 17 soit uniquement opaque vis-à-vis des rayonnements lumineux 16 en provenance des diodes électroluminescentes 11, il est très avantageux de garantir que ce deuxième matériau soit tel que les parois de confinement lumineux 17 soient réfléchissantes pour les rayonnements lumineux 16 en provenance des diodes électroluminescentes 11. Cela permet d'augmenter le rendement de l'ensemble et éventuellement de faire une émission des rayonnements lumineux 16 hors du dispositif optoélectronique 10 du côté de la face arrière après retrait du substrat 13.

Le deuxième matériau ayant de telles propriétés réfléchissantes vis-à-vis des rayonnements lumineux 16 peut être formé d'un même matériau réfléchissant ou d'une pluralité de différents matériaux déposés les uns sur les autres. Les matériaux réfléchissants peuvent être choisis parmi l'aluminium, l'argent, le nickel, le platine, ou tout autre matériau adapté.

En référence à la figure 4, l'étape de formation des parois de confinement lumineux 17 comprend une étape de dépôt d'une couche mince 19 du deuxième matériau mise en œuvre de sorte que cette couche mince 19 du deuxième matériau recouvre non seulement les flancs latéraux 141 des parois d'espacement 14 en étant à leur contact direct mais également, en étant à son contact ou non (par exemple dans le cas où les bordures supérieures 112 sont déjà recouvertes par la couche formant la deuxième électrode supérieure et/ou par une partie de parois d'espacement 14), la bordure supérieure 112 de chacune des diodes électroluminescentes 11.

Comme c'est illustré sur la figure 4, l'étape de dépôt de la couche mince 19 du deuxième matériau comprend une étape de remplissage, par cette couche mince 19 du deuxième matériau, des espaces vides délimités entre les parois d'espacement 14 au niveau des zones 18 entre les diodes électroluminescentes 11.

Le dépôt de la couche mince 19 peut être réalisé par toute technique connue de l'Homme du Métier, le choix pouvant par exemple dépendre de la nature du matériau déposé, de son épaisseur ou des vides séparant extérieurement les parois d'espacement 14. L'épaisseur de la couche mince 19 déposée peut être supérieure à la hauteur H des diodes électroluminescentes 11 de manière suffisante afin de s'assurer que le deuxième matériau puisse recouvrir les bordures supérieures 112 des diodes électroluminescentes 11, dans le cas où une réflexion des rayonnements lumineux 16 est désirée à cet emplacement. Mais comme le montre la figure 9, il est possible de parvenir à ce que la couche mince destinée à former les parois de confinement lumineux 17 recouvre les bordures supérieures 112 des diodes 11 malgré une épaisseur de cette couche mince nettement inférieure à H. Il peut par exemple s'agir d'un dépôt conforme réalisé sur les diodes dont au moins les flancs latéraux sont déjà préalablement recouverts par les parois d'espacement 14.

Le deuxième exemple de mise en œuvre du procédé de fabrication illustré aux figures 11 et 12 prévoit également le dépôt de la couche mince 19 (figure 11) entre et sur les parois d'espacement 14 préalablement formées par un dépôt favorisant une épaisseur irrégulière comme cela l'a déjà été expliqué. Au contact des parois d'espacement 14, la couche mince 19 présente une forme complémentaire des parois d'espacement 14 en venant épouser leurs formes extérieures. Il en résulte qu'il en sera de même pour les parois de confinement lumineux 17 obtenues à la suite du dépôt de la couche mince 19. La couche mince 19 recouvre alors les flancs latéraux et les bordures supérieures des parois d'espacement 14 qui recouvrent elles-mêmes les bordures supérieures 112 et les flancs latéraux 111 des diodes électroluminescentes 11.

Lorsque l'extraction de la lumière émise sera recherchée par la face avant du dispositif optoélectronique 10, c'est-à-dire du côté opposé au substrat 13 ayant servi à la fabrication, le procédé de fabrication sera réalisé de sorte qu'à la fin de l'étape de formation des parois de confinement lumineux 17, la bordure supérieure 112 de chaque diode électroluminescente 11 ne soit pas recouverte par le deuxième matériau de sorte que le rayonnement lumineux 18 en provenance des diodes électroluminescentes 11 soit émis hors du dispositif optoélectronique 10 par une surface d'émission du dispositif optoélectronique 10 située, par rapport aux diodes électroluminescentes 11, du côté des bordures supérieures 112 des diodes électroluminescentes 11 suivant la direction transversale Z.

Ainsi, après l'étape de dépôt de la couche mince 19 du deuxième matériau, l'étape de formation des parois de confinement lumineux 17 peut éventuellement comprendre, pour parvenir à la configuration de la figure 5 ou à la configuration des figures 12 à 14, une étape facultative de gravure et/ou une étape de polissage mécano-chimique de la couche mince 19 du deuxième matériau préalablement déposée, du côté opposé au substrat 13 suivant la direction transversale Z. Cette étape de gravure et/ou de polissage mécano-chimique peut être mise en œuvre par toute technique connue de l'Homme du Métier. Cette étape a notamment pour objectif, lorsque cela est désiré, de faire en sorte que les parois de confinement lumineux 17 ne recouvrent pas les bordures supérieures 112 des diodes électroluminescentes 11, notamment afin de permettre d'émettre les rayonnements lumineux 16 hors du dispositif optoélectronique 10 par la face avant.

Si la figure 12 illustre un exemple dans lequel une planarisation de la couche mince 19 préalablement déposée est réalisée par gravure ou par polissage mécano-chimique jusqu'à retirer tout le deuxième matériau au-dessus des bordures supérieures 112 des diodes électroluminescentes 11, ces bordures supérieures 112 restant recouvertes par du premier matériau correspondant à la paroi d'espacement 14 (les parois de confinement lumineux 17 recouvrant uniquement les flancs latéraux des parois d'espacement 14), la figure 13 schématise la variante de la figure 12 qui correspond au cas particulier où l'étape de gravure de la couche mince 19 est une gravure sélective, en ce sens que seul le deuxième matériau est gravé et le premier matériau reste sensiblement intact (autrement dit, la forme des parois d'espacement 14 est identique au niveau des bordures supérieures 112 des diodes électroluminescentes 11 que ce soit avant ou après ladite étape de gravure de la couche mince 19.

Dans le procédé de fabrication qui vient d'être décrit, les parois d'espacement 14 sur lesquelles les parois de confinement lumineux 17 sont directement formées assurent très avantageusement une fonction d'alignement des parois de confinement lumineux 17 formées. Comme les parois d'espacement 14 sont elles-mêmes formées de manière alignée par rapport aux diodes électroluminescentes 11 qu'elles entourent, il en résulte un phénomène avantageux d'auto-alignement des parois de confinement lumineux 17 par rapport aux diodes électroluminescentes 11. Cela permet d'obtenir des parois de confinement lumineux 17 alignées de manière très précise même dans le cas de diodes électroluminescentes 11 espacées selon un pas très faible dans le plan (X, Y). Il en résulte la possibilité de fournir un dispositif optoélectronique 10 présentant à la fois un fort contraste (grâce à la présence des parois de confinement lumineux 17) et une haute résolution, et ce de manière simple et économique.

Le fait de prévoir que l'étape de formation des parois de confinement lumineux 17 comprenne le dépôt de la couche mince 19 tel que décrit précédemment, c'est-à-dire en particulier où la couche mince 19 recouvre directement les flancs latéraux 141 des parois d'espacement 14 en étant à leur contact et recouvre la bordure supérieure 112 des diodes électroluminescentes 11, permet de proposer une solution simple, non limitante et économique à mettre en œuvre sans grever aucunement les niveaux de contraste et de résolution obtenus.

En référence à la figure 6 qui représente une variante de la figure 5, à la fin de l'étape de formation des parois d'espacement 14, chaque paroi d'espacement 14 présente, du côté de la face support 12 du substrat 13, une épaisseur comptée transversalement à l'axe longitudinal de la diode électroluminescente 11 qu'elle entoure qui diminue progressivement en s'approchant de la face support 12 du substrat 13 suivant la direction transversale Z. Une telle épaisseur décroissante des parois d'espacement 14 du côté du substrat 13 peut être obtenue par un contrôle adapté des conditions du dépôt du premier matériau de manière plus ou moins conforme dans cette zone. L'avantage de ce mode de réalisation est que les parois de confinement lumineux 17 formées sur de telles parois d'espacement 14 présentent une forme complémentaire dans la zone 171, pouvant s'approcher par exemple d'une forme de pseudo-parabole, afin d'améliorer l'extraction de la lumière émise hors du dispositif optoélectronique 10 par la face avant.

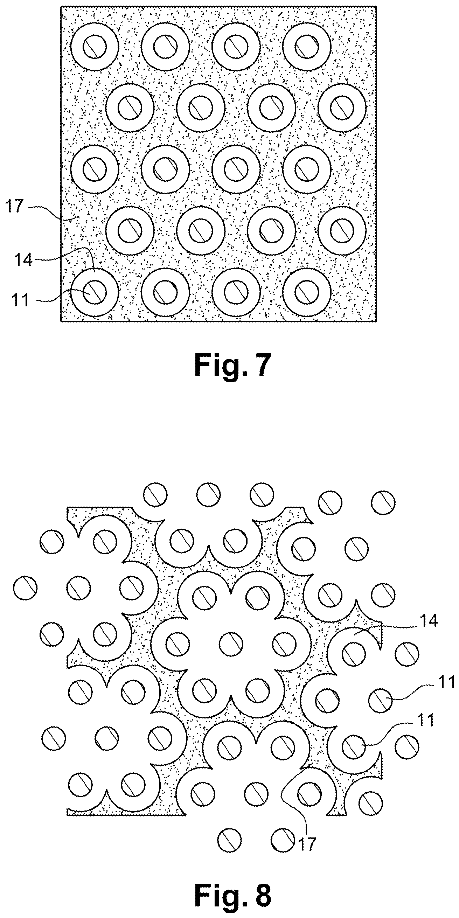

Les figures 7 et 8 représentent, en vue de dessus, partiellement deux exemples de dispositifs optoélectroniques 10 fabriqués par la mise en œuvre du procédé de fabrication des figures 1 à 5. Si la figure 7 permet de montrer que les parois de confinement lumineux 17 formées peuvent être telles que les diodes électroluminescentes 11 soient séparées et rendues individuelles, la figure 8 illustre que le contrôle de l'épaisseur des parois d'espacement 14 formées au niveau des flancs latéraux 112 des diodes électroluminescentes 11 et le contrôle du pas entre les diodes électroluminescentes 11 permettent de réaliser des parois de confinement lumineux 17 pour des sous-pixels à plusieurs diodes électroluminescentes 11. Notamment, en adaptant localement le pas entre les diodes électroluminescentes 11 d'une manière adaptée, il est possible d'obtenir une coalescence des parois d'espacement 14 entre elles pour certaines diodes électroluminescentes 11, comme cela est visible sur la figure 8 contrairement à la figure 7.

Optionnellement, après l'étape de formation des parois de confinement lumineux 17, le procédé comprend une étape de retrait du premier matériau ayant servi à la constitution temporaire des parois d'espacement 14. Si, une fois ce retrait opéré, les vides créés peuvent éventuellement être laissés vides, il est envisageable de prévoir une étape supplémentaire consistant à combler les vides créés par le retrait du premier matériau avec un troisième matériau de comblement. Le troisième matériau de comblement peut par exemple être constitué par un matériau silicone ou par un matériau apte à assurer une fonction de convertisseur de lumière. Tout matériau adapté à cette fonction pourra être envisagé par l'Homme du métier.

Lorsque l'extraction de la lumière émise sera recherchée par la face arrière du dispositif optoélectronique 10, c'est-à-dire du côté de la base des diodes électroluminescentes 11 opposée à leurs bordures supérieures 112, le procédé de fabrication est réalisé de sorte qu'à la fin de l'étape de formation des parois de confinement lumineux 17, la bordure supérieure 112 de chaque diode électroluminescente 11 est également recouverte (directement comme c'est le cas sur la figure 10 ; ou indirectement comme c'est le cas sur la figure 9) par une paroi de confinement lumineux 17 de sorte qu'après la mise en œuvre d'une étape de retrait du substrat 13, le rayonnement lumineux 16 en provenance des diodes électroluminescentes 11 est émis hors du dispositif optoélectronique 10 par une surface d'émission 20 du dispositif optoélectronique 10 située, par rapport aux diodes électroluminescentes 11, du côté opposé aux bordures supérieures 112 des diodes électroluminescentes 11 suivant la direction transversale Z. Il s'agit par exemple des configurations des figures 9 et 10.

Sur chacune des figures 9 et 10, sur lesquelles un seul pixel est représenté à titre purement illustratif, le dispositif optoélectronique 10 comprend donc :
- une matrice de diodes électroluminescentes 11 où chaque diode électroluminescente 11 présente la forme filaire décrite précédemment, c'est-à-dire allongée suivant un axe longitudinal s'étendant suivant la direction transversale Z du dispositif optoélectronique 10,
- les parois d'espacement 14 réalisées dans le premier matériau tel que décrit précédemment, agencées de telle sorte que les flancs latéraux 111 de chaque diode électroluminescente 11, sur toute sa hauteur H, sont entourés par au moins l'une de ces parois d'espacement 14,
- et les parois de confinement lumineux 17 formées dans le deuxième matériau tel que décrit précédemment, et recouvrant directement les flancs latéraux 141 des parois d'espacement 14 en étant à leur contact et recouvrant la bordure supérieure 112 des diodes électroluminescentes 11.

Dans sa structure intermédiaire ou finale telle que représentée sur la figure 4, le dispositif optoélectronique 10 montre bien que les parois de confinement lumineux 17 sont formées par une couche mince 19 du deuxième matériau obtenue par un dépôt mis en œuvre de sorte que ladite couche mince 19 recouvre directement les flancs latéraux des parois d'espacement 14 en étant à leur contact et recouvre la bordure supérieure 112 des diodes électroluminescentes 11 et que les espaces vides délimités entre les parois d'espacement 14 au niveau des zones 18 entre les diodes électroluminescentes 11 sont remplis par ladite couche mince 19 du deuxième matériau.

Dans chacun des exemples des figures 9 et 10, les parois de confinement lumineux 17 qui recouvrent les flancs latéraux 111 des diodes électroluminescentes 11 permettent que le rayonnement lumineux 16 en provenance de chaque diode électroluminescente 11 et dirigé en direction des diodes électroluminescentes 11 adjacentes soit bloqué par la paroi de confinement lumineux 17 qui recouvre la paroi d'espacement 14 qui entoure cette diode électroluminescente 11. Dans le même temps, par le fait que les parois de confinement lumineux 17 recouvrent également les bordures supérieures 112 des diodes électroluminescentes 11, le rayonnement lumineux 16 en provenance des diodes électroluminescentes 11 est émis hors du dispositif optoélectronique 10 par une surface d'émission 20 du dispositif optoélectronique 10 située, par rapport aux diodes électroluminescentes 11, du côté opposé aux bordures supérieures 112 des diodes électroluminescentes 11 suivant la direction transversale Z.

Dans chacun des exemples des figures 9 et 10, la couche d'électrode inférieure 21, déjà évoquée, formée après retrait du substrat 13, est transparente au rayonnement lumineux 16 en provenance des diodes électroluminescentes 11. La couche d'électrode inférieure 21 est en contact électrique avec les bordures inférieures des diodes électroluminescentes 11 afin que la première électrode inférieure soit commune à plusieurs diodes électroluminescentes 11. Ainsi, à la suite de la formation des diodes électroluminescentes 11, des parois d'espacement 14 et des parois de confinement 17, le procédé de fabrication comprend une étape de retrait du substrat 13 puis une étape de formation de la couche d'électrode inférieure 21, typiquement par dépôt, sur la face libérée après le retrait du substrat 13. Le matériau utilisé pour la formation de la couche d'électrode inférieure 21 peut par exemple être choisi parmi tous les oxydes transparents conducteurs connus de l'Homme du Métier, également connus sous l'acronyme « TCO » pour « Transparent Conductive Oxide » en anglais.

Pour obtenir le dispositif optoélectronique 10 de la figure 9, au moins une couche isolante 23 est formée sur la face supérieure du substrat 13 avant la formation des diodes électroluminescentes 11, ladite au moins une couche isolante 23 permettant d'éviter un contact électrique entre la couche d'électrode inférieure 21 et la couche d'électrode supérieure 22.

Sur la figure 9, chaque diode électroluminescente 11 est de type cœur-coquille. Ces diodes électroluminescentes 11 sont par exemple obtenues via une croissance épitaxiale depuis une couche continue de nucléation ou depuis des plots de nucléation répartis sur le substrat 13, dans la couche isolante 23. Le dispositif optoélectronique 10 comprend aussi la couche d'électrode supérieure 22 formée dans un matériau électriquement conducteur et transparent au rayonnement lumineux émis par les diodes électroluminescentes 11. La couche d'électrode supérieure 22, dont le matériau utilisé peut être choisi parmi tous les oxydes transparents conducteurs TCO connus de l'Homme du Métier, recouvre directement les flancs latéraux 111 et la bordure supérieure 112 des diodes électroluminescentes 11 en étant à leur contact de sorte à constituer une deuxième électrode supérieure commune à plusieurs diodes électroluminescentes 11. Les parois d'espacement 14 recouvrent ensuite directement les flans latéraux et la bordure supérieure de la couche d'électrode supérieure 22 en étant à leur contact. Puis les parois de confinement lumineux 17 sont formées. La couche d'électrode supérieure 22 est en contact électrique avec au moins l'une des parois de confinement lumineux 17 qui sont formées sur les parois d'espacement 14, notamment dans leur partie supérieure. Le substrat 13 est retiré puis la couche d'électrode inférieure 21 est formée sur ladite au moins une couche isolante 23 et pour être en contact avec les bordures inférieures des diodes électroluminescentes. Le décrochement repéré 24 permet d'illustrer la gravure subie par le deuxième matériau par sa face avant, pour isoler les deuxièmes électrodes supérieures d'un sous-pixel à l'autre. Les parois de confinement lumineux 17 sont noyées extérieurement dans une première couche isolante 25, sur laquelle est formé le dispositif d'alimentation et de pilotage 26 moyennant un contact électrique entre ce dispositif 26 et les parties supérieures des parois de confinement lumineux 17. Le dispositif d'alimentation et de pilotage 26 est lui-même noyé dans une deuxième couche isolante 27. Toutes les techniques connues pour former le dispositif d'alimentation et de pilotage 26, la première couche isolante 25 et la deuxième couche isolante 27, peuvent être envisagées.

Il est compris que dans le dispositif optoélectronique 10 de la figure 9, les parois de confinement lumineux 17, grâce à leurs propriétés conductrices, entrent dans la constitution de la deuxième électrode supérieure en complément des couches d'électrode supérieure 22 qui, quant à elles, sont directement en contact avec les deuxièmes portions dopées de la coque des diodes électroluminescentes 11. Elles participent à la connexion électrique vis-à-vis du dispositif d'alimentation et de pilotage 26.

Le dispositif optoélectronique 10 de la figure 10 est sensiblement identique à celui de la figure 9 à la différence que chaque diode électroluminescente 11 présente ici une structure axiale et que la couche d'électrode supérieure 22 est absente du fait de la structure axiale des diodes électroluminescentes 11. La couche électriquement isolante 23 formée sur la couche d'électrode inférieure 21 permet ici d'éviter un contact électrique entre la couche d'électrode inférieure 21 et les parois de confinement lumineux 17 qui remplissent à elles-seules la fonction de deuxième électrode supérieure. Ce sont les secondes portions dopées des diodes électroluminescentes 11 qui sont en contact direct avec les parois de confinement lumineux 17, au niveau des bordures supérieures 112 des diodes électroluminescentes 11.

L'étape de formation des parois d'espacement 14 peut optionnellement être mise en œuvre, notamment dans le cas où le deuxième matériau est tel que les parois de confinement lumineux 17 sont réfléchissantes pour le rayonnement lumineux 16 en provenance des diodes électroluminescentes 11, de sorte que les parois d'espacement 14 formées présentent une face externe de forme convexe. Les parois de confinement lumineux 17 présentent alors avantageusement une face interne 172 ayant une forme concave complémentaire de la forme convexe délimitée par la paroi d'espacement 14 qu'elle recouvre. La forme concave formée par la face interne 172 est tournée vers la diode électroluminescente 11 dont elle confine le rayonnement lumineux 16.

Les formes convexes délimitées par les parois d'espacement 14 peuvent, à titre d'exemple, être paraboliques, de sorte que les parois de confinement lumineux 17 présentent alors une forme parabolique concave complémentaire, comme c'est le cas sur chacune des figures 9 et 10. Il est alors très avantageux, dans le cas de diodes électroluminescentes 11 ayant une structure axiale, de faire en sorte, par un contrôle adapté des conditions de formation des parois d'espacement 14, que cette parabole concave soit conformée de telle sorte que la partie active de la diode électroluminescente 11 apte à émettre le rayonnement lumineux 16 soit située au foyer de la parabole concave.

Toutefois, les parois d'espacement 14 peuvent présenter des formes convexes d'autres natures, comme par exemple une forme tronconique, de sorte que les parois de confinement lumineux 17 présentent alors une forme tronconique complémentaire.

Ces dispositions peuvent s'avérer avantageux lorsque l'on souhaite que la lumière émise subisse une collimation dans un cône réduit, comme par exemple une ouverture de faisceau de lumière caractérisé par une valeur NA (pour « Numerical Aperture », en anglais) de l'ordre de 0,3. L'effet de telles formes concaves des faces internes 172 réfléchissantes est d'autant plus efficace pour une diode électroluminescente 11 de forme filaire afin d'assurer la collimation de la lumière émise de sorte à être émise en partie parallèlement à l'axe des premières portions dopées de forme filaire des diodes électroluminescentes 11, alors que de telles diodes électroluminescentes 11 présentent intrinsèquement un champ lointain en forme de cœur.

Dans l'exemple de dispositif optoélectronique 10 de la figure 14, au contraire des dispositions des figures 9 et 10, les parois de confinement lumineux 17 ne recouvrent pas la bordure supérieure des diodes électroluminescentes 11 de sorte que le rayonnement lumineux 16 en provenance des diodes électroluminescentes 11 est émis hors du dispositif optoélectronique 10 par une surface d'émission du dispositif optoélectronique 10 située, par rapport aux diodes électroluminescentes 11, du côté des bordures supérieures 112 des diodes électroluminescentes 11 suivant la direction transversale Z.

Sur la figure 14, sur laquelle seules deux diodes électroluminescentes 11 sont représentées à titre purement illustratif, le dispositif optoélectronique 10 comprend donc :
- une matrice de diodes électroluminescentes 11 où chaque diode électroluminescente 11 présente la forme filaire décrite précédemment, c'est-à-dire allongée suivant un axe longitudinal s'étendant suivant la direction transversale Z du dispositif optoélectronique 10,
- les parois d'espacement 14 réalisées dans le premier matériau tel que décrit précédemment, agencées de telle sorte que les flancs latéraux de chaque diode électroluminescente 11, sur toute sa hauteur H, sont entourés par au moins l'une de ces parois d'espacement 14,
- et les parois de confinement lumineux 17 formées dans le deuxième matériau tel que décrit précédemment, et recouvrant directement les flancs latéraux 141 des parois d'espacement 14 en étant à leur contact mais ne recouvrant pas la bordure supérieure des diodes électroluminescentes 11.

Dans l'exemple de la figure 14, la première électrode inférieure est constituée par le substrat 13 lui-même. Les bordures inférieures des diodes électroluminescentes 11 sont en contact avec le substrat 13, par exemple au travers de la couche de nucléation ou des plots de nucléation, pour établir le contact électrique. Le substrat 13 intègre dans son épaisseur des éléments d'isolation électrique 30 s'étendant à travers le substrat 13 et délimitant deux à deux des portions du substrat 13 isolées entre elles électriquement.

Les éléments d'isolation électrique 30 peuvent comprendre des tranchées s'étendant chacune sur toute l'épaisseur du substrat 13 et remplie d'un matériau électriquement isolant, par exemple un oxyde, notamment de l'oxyde de silicium, ou un polymère isolant. A titre de variante, comme cela est illustré sur la figure 14, les parois de chaque tranchée sont recouvertes d'une couche isolante 31, le reste de la tranchée étant remplie d'un matériau 32 semiconducteur ou conducteur, par exemple du silicium polycristallin. Selon une autre variante, les éléments d'isolation électrique 30 comprennent des régions dopées d'un type de polarité opposé au substrat 13. A titre d'exemple, chaque tranchée a une largeur supérieure à 1 micron. Les éléments d'isolation électrique 30 peuvent comprendre une première série de telles tranchées orientées selon la direction latérale Y et ainsi échelonnées le long de la direction longitudinale X et une seconde série de telles tranchées orientées selon la direction longitudinale X et donc échelonnées le long de la direction latérale Y. Cela permet de parvenir à une organisation matricielle des diodes électroluminescentes 11 dans le plan du substrat 13.

Il est précisé ici que de tels éléments d'isolation électrique 30 peuvent tout à fait être implémentés même dans le cas où le substrat 13 est formé dans un matériau semiconducteur ou électriquement isolant, pour des raisons de résistance thermique.

Des contacts électriques 33 nécessaires à la pixellisation du dispositif optoélectronique 10 sont formés sur la face arrière du dispositif optoélectronique 10. Plus précisément, les contacts électriques 33 sont formés de sorte à être en contact électrique avec la face arrière du substrat 13.

Pour obtenir le dispositif optoélectronique 10 de la figure 14, au moins une couche isolante 23 est formée sur la face supérieure du substrat 13 avant la formation des diodes électroluminescentes 11, ladite au moins une couche isolante 23 permettant d'éviter un contact électrique entre le substrat 13 et la couche d'électrode supérieure 22.

Sur la figure 14, chaque diode électroluminescente 11 est par exemple obtenue via une croissance épitaxiale depuis une couche continue de nucléation ou depuis des plots de nucléation répartis sur le substrat 13, dans des ouvertures de la couche isolante 23. Le dispositif optoélectronique 10 comprend aussi la couche d'électrode supérieure 22 formée dans un matériau électriquement conducteur et transparent au rayonnement lumineux émis par les diodes électroluminescentes 11. La couche d'électrode supérieure 22, dont le matériau utilisé peut être choisi parmi tous les oxydes transparents conducteurs TCO connus de l'Homme du Métier, recouvre directement les flancs latéraux 111 et la bordure supérieure 112 des diodes électroluminescentes 11 en étant à leur contact de sorte à constituer une deuxième électrode supérieure commune à plusieurs diodes électroluminescentes 11. Les parois d'espacement 14 recouvrent ensuite directement les flans latéraux et la bordure supérieure de la couche d'électrode supérieure 22 en étant à leur contact. Puis les parois de confinement lumineux 17 sont formées. La couche d'électrode supérieure 22 est en contact électrique avec au moins l'une des parois de confinement lumineux 17 qui sont formées sur les parois d'espacement 14, dans la zone d'interface repérée 28 entre la couche d'électrode supérieure 22 et les parois de confinement lumineux 17. Les parois de confinement 17 sont discontinus, notamment sous la forme de décrochements obtenus par une gravure du deuxième matériau par sa face avant, pour isoler les deuxièmes électrodes supérieures d'un sous-pixel à l'autre. Un matériau électriquement isolant 29 peut être rapporté dans ces décrochement.

Dans une variante non illustrée de la figure 14, où la première électrode inférieure n'est plus constituée par le substrat 13 lui-même, le substrat 13 est retiré puis une couche d'électrode inférieure est formée sur ladite au moins la couche isolante 23 précédemment formée sur le substrat 13, cette couche d'électrode inférieure étant en contact avec les bordures inférieures des diodes électroluminescentes 11. Puis des contacts électriques nécessaires à la pixellisation du dispositif optoélectronique 10 sont formés sur la face arrière du dispositif optoélectronique 10. Plus précisément, les contacts électriques sont alors formés de sorte à être en contact électrique avec la face arrière de la couche d'électrode inférieure.

## Revendications

1. Procédé de fabrication d'un dispositif optoélectronique (10) comportant une matrice de diodes électroluminescentes (11), comportant les étapes suivantes :
- formation de la matrice de diodes électroluminescentes (11) sur une face support (12) d'un substrat (13), cette étape étant réalisée de sorte que chaque diode électroluminescente (11) présente une forme filaire allongée suivant un axe longitudinal s'étendant suivant une direction transversale (Z) du dispositif optoélectronique (10) orientée transversalement à la face support (12) du substrat (13),
- formation de parois d'espacement (14) réalisées dans un premier matériau diélectrique et transparent au rayonnement lumineux (16) en provenance des diodes électroluminescentes (11), les parois d'espacement (14) formées étant telles que les flancs latéraux (111) de chaque diode électroluminescente (11), sur toute sa hauteur (H) comptée selon la direction transversale (Z), sont entourés par au moins l'une des parois d'espacement (14),
- formation de parois de confinement lumineux (17) formées dans un deuxième matériau apte à bloquer le rayonnement lumineux (16) en provenance des diodes électroluminescentes (11), les parois de confinement lumineux (17) formées recouvrant directement les flancs latéraux (141) des parois d'espacement (14) en étant à leur contact, de sorte que le rayonnement lumineux (16) en provenance de chaque diode électroluminescente (11) et dirigé en direction des diodes électroluminescentes (11) adjacentes est bloqué par la paroi de confinement lumineux (17) qui recouvre la paroi d'espacement (14) qui entoure ladite diode électroluminescente (11),
**caractérisé en ce que** l'étape de formation de parois de confinement lumineux (17) comprend une étape de dépôt d'une couche mince (19) du deuxième matériau mise en œuvre de sorte que cette couche mince (19) du deuxième matériau recouvre directement les flancs latéraux (141) des parois d'espacement (14) en étant à leur contact et recouvre la bordure supérieure (112) des diodes électroluminescentes (11) et **en ce que** l'étape de dépôt de la couche mince (19) du deuxième matériau comprend une étape de remplissage, par ladite couche mince (19) du deuxième matériau, des espaces vides délimités entre les parois d'espacement (14) au niveau des zones (18) entre les diodes électroluminescentes (11).

2. Procédé de fabrication selon la revendication 1, dans lequel l'étape de formation des parois d'espacement (14) comprend une étape de dépôt d'une couche mince (15) du premier matériau, mise en œuvre de sorte que la couche mince (15) déposée recouvre les flancs latéraux (111) et la bordure supérieure (112) des diodes électroluminescentes (11).

3. Procédé de fabrication selon la revendication 2, dans lequel après l'étape de dépôt de la couche mince (15) du premier matériau, l'étape de formation des parois d'espacement (14) comprend une étape de gravure de la couche mince (15) du premier matériau précédemment déposée localisée au niveau des bordures supérieures (112) des diodes électroluminescentes (11) et au niveau des zones (18) entre les diodes électroluminescentes (11).

4. Procédé de fabrication selon l'une quelconque des revendications 1 à 3, dans lequel le deuxième matériau utilisé dans l'étape de formation des parois de confinement lumineux (17) est tel que les parois de confinement lumineux (17) sont réfléchissantes pour le rayonnement lumineux (16) en provenance des diodes électroluminescentes (11).

5. Procédé de fabrication selon l'une quelconque des revendications 1 à 4, dans lequel à la fin de l'étape de formation des parois de confinement lumineux (17), la bordure supérieure (112) de chaque diode électroluminescente (11) n'est pas recouverte par le deuxième matériau de sorte que le rayonnement lumineux (16) en provenance des diodes électroluminescentes (11) est émis hors du dispositif optoélectronique (10) par une surface d'émission du dispositif optoélectronique (10) située, par rapport aux diodes électroluminescentes (11), du côté des bordures supérieures (112) des diodes électroluminescentes (11) suivant la direction transversale (Z).

6. Procédé de fabrication selon l'une quelconque des revendications 1 à 4, dans lequel à la fin de l'étape de formation des parois de confinement lumineux (17), la bordure supérieure (112) de chaque diode électroluminescente (11) est recouverte par une paroi de confinement lumineux (17) de sorte qu'après la mise en œuvre d'une étape de retrait du substrat (13), le rayonnement lumineux (16) en provenance des diodes électroluminescentes (11) est émis hors du dispositif optoélectronique (10) par une surface d'émission (20) du dispositif optoélectronique (10) située, par rapport aux diodes électroluminescentes (11), du côté opposé aux bordures supérieures (112) des diodes électroluminescentes (11) suivant la direction transversale (Z).

7. Procédé de fabrication selon la revendication 6, dans lequel l'étape de formation des parois d'espacement (14) est mise en œuvre de sorte que les parois d'espacement (14) formées présentent une face externe de forme convexe, notamment tronconique, et en ce que les parois de confinement lumineux (17) formées présentent une face interne (172) ayant une forme concave complémentaire de ladite forme convexe et tournée vers la diode électroluminescente (11) dont elle confine le rayonnement lumineux (16).

8. Procédé de fabrication selon l'une quelconque des revendications 1 à 7, dans lequel le premier matériau utilisé pour la formation des parois d'espacement (14) comporte des particules photoluminescentes qui se présentent sous la forme de boîtes quantiques.

9. Dispositif optoélectronique (10) comprenant :
- une matrice de diodes électroluminescentes (11) où chaque diode électroluminescente (11) présente une forme filaire allongée suivant un axe longitudinal s'étendant suivant une direction transversale (Z) du dispositif optoélectronique (10),
- des parois d'espacement (14) réalisées dans un premier matériau diélectrique et transparent au rayonnement lumineux (16) en provenance des diodes électroluminescentes (11) et agencées de telle sorte que les flancs latéraux (111) de chaque diode électroluminescente (11), sur toute sa hauteur (H) comptée selon la direction transversale (Z), sont entourés par au moins l'une des parois d'espacement (14),
- et des parois de confinement lumineux (17) formées dans un deuxième matériau apte à bloquer le rayonnement lumineux (16) en provenance des diodes électroluminescentes (11), les parois de confinement lumineux (17) recouvrant directement les flancs latéraux (141) des parois d'espacement (14) en étant à leur contact, le rayonnement lumineux (16) en provenance de chaque diode électroluminescente (11) et dirigé en direction des diodes électroluminescentes (11) adjacentes étant bloqué par la paroi de confinement lumineux (17) qui recouvre la paroi d'espacement (14) qui entoure ladite diode électroluminescente (11),
**caractérisé en ce que** les parois de confinement lumineux (17) sont formées par une couche mince (19) du deuxième matériau obtenue par un dépôt mis en œuvre de sorte que ladite couche mince (19) recouvre directement les flancs latéraux des parois d'espacement (14) en étant à leur contact et recouvre la bordure supérieure (112) des diodes électroluminescentes (11) et **en ce que** les espaces vides délimités entre les parois d'espacement (14) au niveau des zones (18) entre les diodes électroluminescentes (11) sont remplis par ladite couche mince (19) du deuxième matériau.

10. Dispositif optoélectronique (10) selon la revendication 9, dans lequel les parois de confinement lumineux (17) recouvrent la bordure supérieure (112) des diodes électroluminescentes (11) et en ce que le rayonnement lumineux (16) en provenance des diodes électroluminescentes (11) est émis hors du dispositif optoélectronique (10) par une surface d'émission (20) du dispositif optoélectronique (10) située, par rapport aux diodes électroluminescentes (11), du côté opposé aux bordures supérieures (112) des diodes électroluminescentes (11) suivant la direction transversale (Z).

11. Dispositif optoélectronique (10) selon la revendication 10, dans lequel le deuxième matériau est tel que les parois de confinement lumineux (17) sont réfléchissantes pour le rayonnement lumineux (16) en provenance des diodes électroluminescentes (11) et en ce que les parois d'espacement (14) présentent une face externe de forme convexe et les parois de confinement lumineux présentent une face interne (172) ayant une forme concave complémentaire de ladite forme convexe et tournée vers la diode électroluminescente (11) dont elle confine le rayonnement lumineux (16).

12. Dispositif optoélectronique (10) selon l'une des revendications 10 ou 11, comprenant une couche d'électrode inférieure (21) formée dans un matériau électriquement conducteur et transparent au rayonnement lumineux (16), ladite couche d'électrode inférieure (21) étant en contact électrique avec les bordures inférieures des diodes électroluminescentes (11) afin de remplir une fonction de première électrode commune à plusieurs diodes électroluminescentes (11).

13. Dispositif optoélectronique (10) selon l'une des revendications 10 à 12, dans lequel chaque diode électroluminescente (11) est de type cœur-coquille et en ce qu'il comprend une couche d'électrode supérieure (22) formée dans un matériau électriquement conducteur et transparent au rayonnement lumineux (16), la couche d'électrode supérieure (22) recouvrant directement les flancs latéraux (111) et la bordure supérieure (112) des diodes électroluminescentes (11) en étant à leur contact de sorte à remplir une fonction de seconde électrode commune à plusieurs diodes électroluminescentes (11), les parois d'espacement (14) recouvrant directement les flans latéraux et la bordure supérieure de la couche d'électrode supérieure (22) en étant à leur contact et la couche d'électrode supérieure (22) étant en contact électrique avec au moins l'une des parois de confinement lumineux (17).

14. Dispositif optoélectronique (10) selon la revendication 9, dans lequel les parois de confinement lumineux (17) ne recouvrent pas la bordure supérieure (112) des diodes électroluminescentes (11) et en ce que le rayonnement lumineux (16) en provenance des diodes électroluminescentes (11) est émis hors du dispositif optoélectronique (10) par une surface d'émission du dispositif optoélectronique (10) située, par rapport aux diodes électroluminescentes (11), du côté des bordures supérieures (112) des diodes électroluminescentes (11) suivant la direction transversale (Z).

## Patentansprüche

1. Fertigungsverfahren für eine optoelektronische Vorrichtung (10), die eine Matrize von Leuchtdioden (11) enthält, das die folgenden Schritte enthält:
- Bildung der Matrize von Leuchtdioden (11) auf einer Trägerfläche (12) eines Substrats (13), wobei dieser Schritt so realisiert wird, dass jede Leuchtdiode (11) eine längliche drahtige Form entlang einer Längsachse aufweist, die sich entlang einer Querrichtung (z) der optoelektronischen Vorrichtung (10) erstreckt, die quer zur Trägerfläche (12) des Substrats (13) ausgerichtet ist,
- Bildung von Abstandswänden (14), realisiert aus einem ersten dielektrischen und für die Lichtstrahlung (16), die von den Leuchtdioden (11) ausgeht, durchlässigen Material, wobei die gebildeten Abstandswände (14) so sind, dass die Seitenflanken (111) jeder Leuchtdiode (11) über ihre gesamte Höhe (H), die in der Querrichtung (Z) gemessen wird, von mindestens einer der Abstandswände (14) umgeben sind,
- Bildung von Lichteingrenzungswänden (17), die aus einem zweiten Material gebildet sind, das die Lichtstrahlung (16), die von den Leuchtdioden (11) ausgeht, blockieren kann, wobei die gebildeten Lichteingrenzungswände (17) direkt die Seitenflanken (141) der Abstandswände (14) bedecken, mit denen sie in Kontakt sind, so dass die Lichtstrahlung (16), die von jeder Leuchtdiode (11) ausgeht, und in Richtung der benachbarten Leuchtdioden (11) gerichtet ist, durch die Lichteingrenzungswand (17) blockiert wird, die die Abstandswand (14) bedeckt, die die Leuchtdiode (11) umgibt,
**dadurch gekennzeichnet, dass** der Schritt der Bildung der Lichteingrenzungswände (17) einen Beschichtungsschritt einer Dünnschicht (19) aus dem zweiten Material umfasst, der so umgesetzt ist, dass die Dünnschicht (19) des zweiten Materials direkt die Seitenflanken (141) der Abstandswände (14) bedeckt, mit denen sie in Kontakt sind, und den oberen Rand (112) der Leuchtdioden (11) bedeckt, und dass der Beschichtungsschritt der Dünnschicht (19) aus dem zweiten Material einen Schritt der Füllung, durch die Dünnschicht (19) aus dem zweiten Material, der zwischen den Abstandswänden (14) begrenzten Leerräume, in den Bereichen (18) zwischen den Leuchtdioden (11) umfasst.

2. Fertigungsverfahren nach Anspruch 1, wobei der Schritt der Bildung der Abstandswände (14) einen Beschichtungsschritt einer Dünnschicht (15) des ersten Materials umfasst, der so umgesetzt ist, dass die aufgebrachte Dünnschicht (15) die Seitenflanken (111) und den oberen Rand (112) der Leuchtdioden (11) bedeckt.

3. Fertigungsverfahren nach Anspruch 2, wobei nach dem Beschichtungsschritt der Dünnschicht (15) des ersten Materials der Schritt der Bildung der Abstandswände (14) einen Schritt des Ätzens der Dünnschicht (15) des zuvor aufgebrachten ersten Materials umfasst, die an den oberen Rändern (112) der Leuchtdioden (11) und an den Bereichen (18) zwischen den Leuchtdioden (11) lokalisiert ist.

4. Fertigungsverfahren nach einem der Ansprüche 1 bis 3, wobei das zweite Material, das im Schritt der Bildung der Lichteingrenzungswände (17) verwendet wird, derart ist, dass die Lichteingrenzungswände (17) für die Lichtstrahlung (16), die von den Leuchtdioden (11) ausgeht, reflektierend sind.

5. Fertigungsverfahren nach einem der Ansprüche 1 bis 4, wobei am Ende des Schrittes der Bildung der Lichteingrenzungswände (17) der obere Rand (112) jeder Leuchtdiode (11) nicht durch das zweite Material bedeckt ist, so dass die Lichtstrahlung (16), die von den Leuchtdioden (11) ausgeht, aus der optoelektronischen Vorrichtung (10) durch eine Emissionsoberfläche der optoelektronischen Vorrichtung (10) emittiert wird, die, in Bezug auf die Leuchtdioden (11), auf der Seite der oberen Ränder (112) der Leuchtdioden (11) angeordnet ist, entlang der Querrichtung (Z).

6. Fertigungsverfahren nach einem der Ansprüche 1 bis 4, wobei am Ende des Schrittes der Bildung der Lichteingrenzungswände (17) der obere Rand (112) jeder Leuchtdiode (11) durch eine Lichteingrenzungswand (17) bedeckt ist, so dass nach der Umsetzung eines Schrittes der Substratentfernung (13) die Lichtstrahlung (16), die von den Leuchtdioden (11) ausgeht, aus der optoelektronischen Vorrichtung (10) durch eine Emissionsoberfläche (20) der optoelektronischen Vorrichtung (10) emittiert wird, die, in Bezug auf die Leuchtdioden (11), auf der Seite gegenüber den oberen Rändern (112) der Leuchtdioden (11) angeordnet ist, entlang der Querrichtung (Z).

7. Fertigungsverfahren nach Anspruch 6, wobei der Schritt der Bildung der Abstandswände (14) so umgesetzt ist, dass die gebildeten Abstandswände (14) eine Außenfläche mit konvexer Form aufweisen, namentlich kegelstumpfförmig, und dass die gebildeten Lichteingrenzungswände (17) eine Innenfläche (172) mit einer konkaven Form aufweisen, die komplementär zur konvexen Form ist und der Leuchtdiode (11) zugewandt, deren Lichtstrahlung (16) sie eingrenzt.

8. Fertigungsverfahren nach einem der Ansprüche 1 bis 7, wobei das erste Material, das zur Bildung der Abstandswände (14) verwendet wird, photolumineszierende Partikel in Form von Quantenpunkten enthält.

9. Optoelektronische Vorrichtung (10), umfassend:
- eine Matrize von Leuchtdioden (11) in der jede Leuchtdiode (11) eine längliche drahtige Form entlang einer Längsachse aufweist, die sich entlang einer Querrichtung (Z) der optoelektronischen Vorrichtung (10) erstreckt,
- Abstandswände (14) realisiert aus einem ersten dielektrischen und für die Lichtstrahlung (16), die von den Leuchtdioden (11) ausgeht, durchlässigen Material und die so eingerichtet sind, dass die Seitenflanken (111) jeder Leuchtdiode (11) über ihre gesamte Höhe (H), die in der Querrichtung (Z) gemessen wird, von mindestens einer der Abstandswände (14) umgeben sind,
- und Lichteingrenzungswände (17), die aus einem zweiten Material gebildet sind, das die Lichtstrahlung (16), die von den Leuchtdioden (11) ausgeht, blockieren kann, wobei die Lichteingrenzungswände (17) direkt die Seitenflanken (141) der Abstandswände (14) bedecken, mit denen sie in Kontakt sind, wobei die Lichtstrahlung (16), die von jeder Leuchtdiode (11) ausgeht und in Richtung benachbarter Leuchtdioden (11) gerichtet ist, durch die Lichteingrenzungswand (17) blockiert wird, die die Abstandswand (14) bedeckt, die die Leuchtdiode (11) umgibt,
**dadurch gekennzeichnet, dass** die Lichteingrenzungswände (17) durch eine Dünnschicht (19) des zweiten Materials gebildet sind, die durch eine Beschichtung erhalten wird, die so umgesetzt ist, dass die Dünnschicht (19) direkt die Seitenflanken der Abstandswände (14) bedeckt, indem sie in Kontakt mit ihnen steht, und den oberen Rand (112) der Leuchtdioden (11) bedeckt und dass die Leerräume zwischen den Abstandswänden (14) in den Bereichen (18) zwischen den Leuchtdioden (11) mit der Dünnschicht (19) des zweiten Materials gefüllt sind.

10. Optoelektronische Vorrichtung (10) nach Anspruch 9, wobei die Lichteingrenzungswände (17) den oberen Rand (112) der Leuchtdioden (11) bedecken und dass die Lichtstrahlung (16), die von den Leuchtdioden (11) ausgeht, aus der optoelektronischen Vorrichtung (10) durch eine Emissionsoberfläche (20) der optoelektronischen Vorrichtung (10) emittiert wird, die, in Bezug auf die Leuchtdioden (11), auf der Seite gegenüber den oberen Rändern (112) der Leuchtdioden (11) angeordnet ist, entlang der Querrichtung (Z).

11. Optoelektronische Vorrichtung (10) nach Anspruch 10, wobei das zweite Material derart ist, dass die Lichteingrenzungswände (17) für die Lichtstrahlung (16), die von den Leuchtdioden (11) ausgeht, reflektierend sind und dass die Abstandswände (14) eine Außenfläche mit konvexer Form aufweisen und die Lichteingrenzungswände eine Innenfläche (172) mit konkaver Form aufweisen, die komplementär zur konvexen Form ist und der Leuchtdiode (11) zugewandt, deren Lichtstrahlung (16) sie eingrenzt.

12. Optoelektronische Vorrichtung (10) nach einem der Ansprüche 10 oder 11, eine untere Elektrodenschicht (21) umfassend, die aus einem elektrisch leitfähigen und für die Lichtstrahlung (16) durchlässigen Material gebildet ist, wobei die untere Elektrodenschicht (21) in elektrischem Kontakt mit den unteren Rändern der Leuchtdioden (11) steht, um eine Funktion der ersten Elektrode zu erfüllen, die für mehrere Leuchtdioden (11) gemeinsam ist.

13. Optoelektronische Vorrichtung (10) nach einem der Ansprüche 10 bis 12, wobei jede Leuchtdiode (11) vom Kern-Schale-Typ ist und eine obere Elektrodenschicht (22) umfasst, die aus einem elektrisch leitfähigen und für die Lichtstrahlung (16) durchlässigen Material gebildet ist, wobei die obere Elektrodenschicht (22) direkt die Seitenflanken (111) und den oberen Rand (112) der Leuchtdioden (11) bedeckt, indem sie mit ihnen in Kontakt steht, so dass eine Funktion der zweiten Elektrode erfüllt wird, die für mehrere Leuchtdioden (11) gemeinsam ist, wobei die Abstandswände (14) direkt die Seitenflanken und den oberen Rand der oberen Elektrodenschicht (22) bedecken, mit denen sie in Kontakt sind, und wobei die obere Elektrodenschicht (22) in elektrischem Kontakt mit mindestens einer der Lichteingrenzungswände (17) steht.

14. Optoelektronische Vorrichtung (10) nach Anspruch 9, wobei die Lichteingrenzungswände (17) den oberen Rand (112) der Leuchtdioden (11) nicht bedecken und dass die Lichtstrahlung (16), die von den Leuchtdioden (11) ausgeht, aus der optoelektronischen Vorrichtung (10) durch eine Emissionsoberfläche der optoelektronischen Vorrichtung (10) emittiert wird, die, in Bezug auf die Leuchtdioden (11), auf der Seite der oberen Ränder (112) der Leuchtdioden (11) angeordnet ist, entlang der Querrichtung (Z).

## Claims

1. A method for manufacturing an optoelectronic device (10) comprising an array of light-emitting diodes (11), including the following steps:
- forming the array of light-emitting diodes (11) on a support face (12) of a substrate (13), this step being carried out so that each light-emitting diode (11) has an elongated wire shape along a longitudinal axis extending along a transverse direction (Z) of the optoelectronic device (10) oriented transversely to the support face (12) of the substrate (13),
- forming spacer walls (14) made of a first dielectric material transparent to the light radiation (16) coming from the light-emitting diodes (11), the formed spacer walls (14) being such that the lateral sidewalls (111) of each light-emitting diode (11), over its entire height (H) considered in the transverse direction (Z), are surrounded by at least one of the spacer walls (14),
- forming light confinement walls (17) formed of a second material adapted to block the light radiation (16) coming from the light-emitting diodes (11), the formed light confinement walls (17) directly covering the lateral sidewalls (141) of the spacer walls (14) while being in contact with them, so that the light radiation (16) coming from each light-emitting diode (11) and directed in the direction of the adjacent light-emitting diodes (11) is blocked by the light confinement wall (17) which covers the spacer wall (14) which surrounds said light-emitting diode (11),
**characterized in that** the step of forming light confinement walls (17) comprises a step of depositing a thin layer (19) of the second material implemented so that this thin layer (19) of the second material directly covers the lateral sidewalls (141) of the spacer walls (14) while being in contact with them and covers the upper edge (112) of the light-emitting diodes (11) and **in that** the step of depositing the thin layer (19) of the second material comprises a step of filling, by said thin layer (19) of the second material, the empty spaces delimited between the spacer walls (14) at the level of the areas (18) between the light-emitting diodes (11).

2. The manufacturing method according to claim 1, wherein the step of forming the spacer walls (14) comprises a step of depositing a thin layer (15) of the first material, implemented so that the deposited thin layer (15) covers the lateral sidewalls (111) and the upper edge (112) of the light-emitting diodes (11).

3. The manufacturing method according to claim 2, wherein, after the step of depositing the thin layer (15) of the first material, the step of forming the spacer walls (14) comprises a step of etching the thin layer (15) of the previously deposited first material located at the level of the upper edges (112) of the light-emitting diodes (11) and at the level of the areas (18) between the light-emitting diodes (11).

4. The manufacturing method according to any one of claims 1 to 3, wherein the second material used in the step of forming the light confinement walls (17) is such that the light confinement walls (17) are reflective for the light radiation (16) coming from the light-emitting diodes (11).

5. The manufacturing method according to any one of claims 1 to 4, wherein, at the end of the step of forming the light confinement walls (17), the upper edge (112) of each light-emitting diode (11) is not covered by the second material so that the light radiation (16) coming from the light-emitting diodes (11) is emitted out of the optoelectronic device (10) by an emission surface of the optoelectronic device (10) located, with respect to the light-emitting diodes (11), on the side of the upper edges (112) of the light-emitting diodes (11) along the transverse direction (Z).

6. The manufacturing method according to any one of claims 1 to 4, wherein, at the end of the step of forming the light confinement walls (17), the upper edge (112) of each light-emitting diode (11) is covered by a light confinement wall (17) so that, after the implementation of a step of removing the substrate (13), the light radiation (16) coming from the light-emitting diodes (11) is emitted out of the optoelectronic device (10) by an emission surface (20) of the optoelectronic device (10) located, with respect to the light-emitting diodes (11), on the side opposite to the upper edges (112) of the light-emitting diodes (11) along the transverse direction (Z).

7. The manufacturing method according to claim 6, wherein the step of forming the spacer walls (14) is implemented so that the formed spacer walls (14) have an outer face with a convex shape, in particular frustoconical, and in that the formed light confinement walls (17) have an inner face (172) having a concave shape complementary to said convex shape and facing the light-emitting diode (11) that they confine the light radiation (16) thereof.

8. The manufacturing method according to any one of claims 1 to 7, wherein the first material used for forming the spacer walls (14) includes photoluminescent particles which are in the form of quantum dots.

9. An optoelectronic device (10) comprising:
- an array of light-emitting diodes (11) where each light-emitting diode (11) has an elongated wire shape along a longitudinal axis extending along a transverse direction (Z) of the optoelectronic device (10),
- spacer walls (14) made of a first dielectric material transparent to the light radiation (16) coming from the light-emitting diodes (11) and arranged such that the lateral sidewalls (111) of each light-emitting diode (11), over its entire height (H) considered in the transverse direction (Z), are surrounded by at least one of the spacer walls (14),
- and light confinement walls (17) formed of a second material adapted to block the light radiation (16) coming from the light-emitting diodes (11), the light confinement walls (17) directly covering the lateral sidewalls (141) of the spacer walls (14) while being in contact with them, the light radiation (16) coming from each light-emitting diode (11) and directed in the direction of the adjacent light-emitting diodes (11) being blocked by the light confinement wall (17) which covers the spacer wall (14) which surrounds said light-emitting diode (11),
**characterized in that** the light confinement walls (17) are formed by a thin layer (19) of the second material obtained by a deposit implemented so that said thin layer (19) directly covers the lateral sidewalls of the spacer walls (14) while being in contact with them and covers the upper edge (112) of the light-emitting diodes (11) and **in that** the empty spaces delimited between the spacer walls (14) at the level of the areas (18) between the light-emitting diodes (11) are filled with said thin layer (19) of the second material.

10. The optoelectronic device (10) according to claim 9, wherein the light confinement walls (17) cover the upper edge (112) of the light-emitting diodes (11) and in that the light radiation (16) coming from the light-emitting diodes (11) is emitted out of the optoelectronic device (10) by an emission surface (20) of the optoelectronic device (10) located, with respect to the light-emitting diodes (11), on the side opposite to the upper edges (112) of the light-emitting diodes (11) along the transverse direction (Z).

11. The optoelectronic device (10) according to claim 10, wherein the second material is such that the light confinement walls (17) are reflective for the light radiation (16) coming from the light-emitting diodes (11) and in that the spacer walls (14) have an outer face with a convex shape and the light confinement walls have an inner face (172) having a concave shape complementary to said convex shape and facing the light-emitting diode (11) which they confine the light radiation (16) thereof.

12. The optoelectronic device (10) according to any of claims 10 or 11, comprising a lower electrode layer (21) formed of an electrically-conductive material transparent to the light radiation (16), said lower electrode layer (21) being in electrical contact with the lower edges of the light-emitting diodes (11) in order to fulfill a function of a first electrode common to several light-emitting diodes (11).

13. The optoelectronic device (10) according to any of claims 10 to 12, wherein each light-emitting diode (11) is of the core-shell type and in that it comprises an upper electrode layer (22) formed of an electrically-conductive material transparent to the light radiation (16), the upper electrode layer (22) directly covering the lateral sidewalls (111) and the upper border (112) of the light-emitting diodes (11) while being in contact with them so as to fulfill a function of a second electrode common to several light-emitting diodes (11), the spacer walls (14) directly covering the lateral sidewalls and the upper edge of the upper electrode layer (22) while being in contact with them and the upper electrode layer (22) being in electrical contact with at least one of the light confinement walls (17).

14. The optoelectronic device (10) according to claim 9, wherein the light confinement walls (17) do not cover the upper edge (112) of the light-emitting diodes (11) and in that the light radiation (16) coming from the light-emitting diodes (11) is emitted out of the optoelectronic device (10) by an emission surface of the optoelectronic device (10) located, with respect to the light-emitting diodes (11), on the side of the upper edges (112) of the light-emitting diodes (11) along the transverse direction (Z).
